# EUROPEAN PATENT APPLICATION

(11) **EP 4 220 711 A2**
(43) Date of publication of application: **02.08.2023**
(21) Application number: 23153500.6
(22) Date of filing: 26.01.2023
(51) Int. Cl.: H01L 23/552, H01L 25/18, H10B 10/00, H10B 12/00, H10B 80/00

(54) **IC PACKAGE INCLUDING A SUBSTRATE AND THREE MONOLITHIC DIES**

(30) Priority: 27.01.2022 US 202263303542 P
(71) Applicant: Invention And Collaboration Laboratory Pte. Ltd., Singapore 068914 (SG)
(72) Inventor: LU, Chao-Chun, 30078 Hsinchu (TW)
(74) Representative: dompatent von Kreisler Selting Werner - Partnerschaft von Patent- und Rechtsanwälten mbB

(57) **Abstract**

An IC package includes a substrate, a first monolithic die, a second monolithic die and a third monolithic die. A processing unit circuit is formed in the first monolithic die. A plurality of SRAM arrays are formed in the second monolithic die, wherein the plurality of SRAM arrays include at least 5-20G Bytes. A plurality of DRAM arrays are formed in the third monolithic die, wherein the plurality of DRAM arrays include at least 64-512G Bytes. The first monolithic die, the second monolithic die and the third monolithic die are vertically stacked above the substrate. The third monolithic die is electrically connected to the first monolithic die through the second monolithic die.

## Description

### BACKGROUND OF THE DISCLOSURE

### Field of the Disclosure

The disclosure relates in general to a semiconductor structure, and more particularly to a processor integrated circuit (IC) having a plurality of monolithic dies respectively having a processing unit circuit, a plurality of static random access memory (SRAM) arrays or a plurality of dynamic random access memory (DRAM) arrays.

### Description of the Related Art

Information technology (IT) systems are rapidly evolving in businesses and enterprises across the board, including those in factories, healthcare, and transportation. Nowadays, system on chip (SOC) or artificial intelligence (AI) is the keystone of IT systems which is making factories smarter, improving patient outcomes better, increasing autonomous vehicle safety. Data from manufacturing equipment, sensors, machine vision systems could be easily total 1 petaByte per day. Therefore, a high performance computing (HPC) SOC or AI chip is required to handle the such petaByate data.

Generally speaking, AI chips could be categorized by a graphic processing unit (GPU), a field programmable gate array (FPGA), and an application specific IC (ASIC). Originally designed to handle graphical processing applications using parallel computing, GPUs began to be used more and more often for AI training. GPU's training speed and efficiency generally is 10 to1000 times larger than general purpose CPU.

FPGAs have blocks of logic that interact with each other and can be designed by engineers to help specific algorithms, and is suitable for AI inference. Due to faster time to market, lower cost, and flexibility, FPGA prefers over ASIC design although it has disadvantages like larger size, slower speed, and larger power consumption. Due to the flexibility of FPGA, it is possible to partially program any portion of the FPGA depending on the requirement. FPGA's inference speed and efficiency is 10-100 times larger than general purpose CPU.

On the other hand, ASICs are tailored directly to the circuitry and are generally more efficient than FPGAs. For customized ASIC, its training/inference speed and efficiency could be 10-1000 times larger than general purpose CPU. However, unlike FPGAs which are easier to customize as AI algorithms continue to evolve, ASICs are slowly becoming obsolete as new AI algorithms are developed.

No matter in GPU, FPGA, and ASICs (or other similar SOC, CPU, NPU, etc.), logic circuit and SRAM circuit are two major circuit the combination of which approximately occupy around 90% of the AI chip size. The rest 10% of the AI chip may include I/O pads circuit. Nevertheless, the scaling process/technology nodes for manufacturing AI chips are becoming increasingly necessary to train an AI machine efficiently and quickly because they offer better efficiency and performance. Improvement in integrated circuit performance and cost has been achieved largely by process scaling technology according to Moore's Law, but such scaling technology down to 3nm to 5nm encounter a lot of technical difficulties, so the semiconductor industry's investment costs in R&D and capital are dramatically increasing.

For example, SRAM device scaling for increased storage density, reduction in operating voltage (VDD) for lower stand-by power consumption, and enhanced yield necessary to realize larger-capacity SRAM become increasingly difficult to achieve with miniaturization down to the 28 nm (or lower) manufacture process is a challenge.

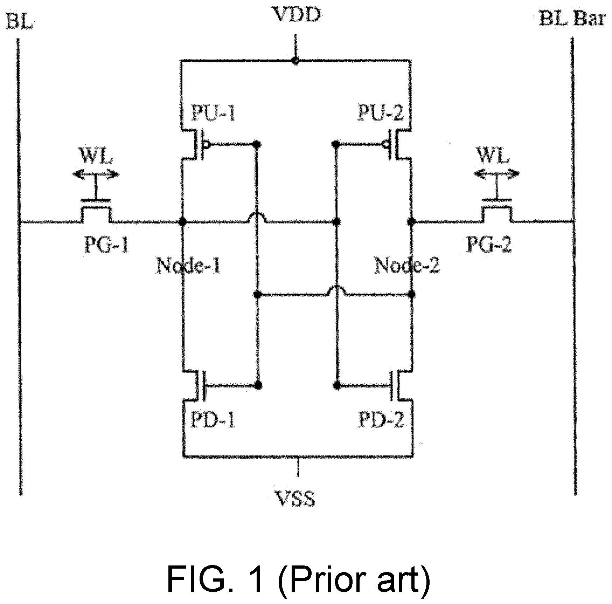

FIG. 1 shows the SRAM cell architecture, that is the six-transistor (6-T) SRAM cell. It consists of two cross-coupled inverters (PMOS pull-up transistors PU-1 and PU-2 and NMOS pull-down transistors PD-1 and PD-2) and two access transistors (NMOS pass-gate transistors PG-1 and PG-2). The high level voltage VDD is coupled to the PMOS pull-up transistors PU-1 and PU-2, and the low level voltage VSS are coupled to the NMOS pull-down transistors PD-1 and PD-2. When the word-line (WL) is enabled (i.e., a row is selected in an array), the access transistors are turned on, and connect the storage nodes (Node-1/Node-2) to the vertically-running bit-lines (BL and BL Bar).

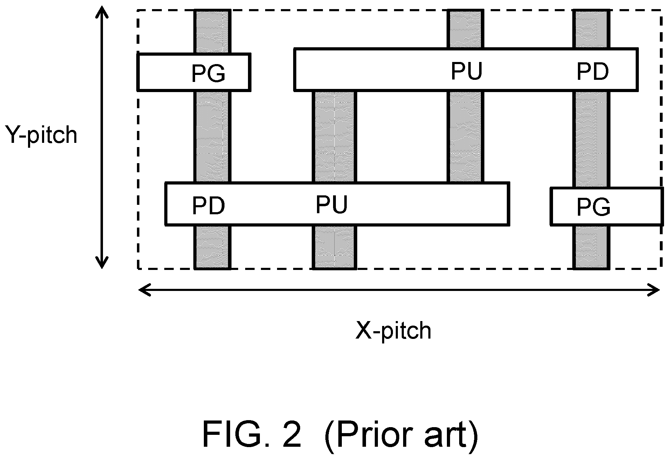

FIG. 2 shows the "stick diagram" representing the layout and connection among the 6 transistors of the SRAM. The stick diagram usually just includes active regions (vertical bars) and gate lines (horizontal bars) to form the pull-down transistors PD and the pull-up transistors PU of the 6 transistors of the SRAM. Of course, there are still lots of contacts, on one hand directly coupled to the 6 transistors, and on the other hand, coupled to the word-line (WL), bit-lines (BL and BL Bar), high level voltage VDD, and low level voltage VSS, etc.

Some of the reasons for the dramatically increase of the total area of the SRAM cell represented by λ² or F² when the minimum feature size decreases could be described as follows. The traditional 6T SRAM has six transistors which are connected by using multiple interconnections, has its first interconnection layer M1 to connect the gate-level ("Gate") and the diffusion-level of the Source-region and the Drain-region (those regions called generally as "Diffusion") of the transistors. There is a need to increase a second interconnection layer M2 and/or a third interconnection layer M3 for facilitating signal transmission (such as the word-line (WL) and/or bit-lines (BL and BL Bar)) without enlarging the die size by only using M1, then a structure Via-1, which is composed of some types of the conductive materials, is formed for connecting the second interconnection layer M2 to the first interconnection layer M1.

Thus, there is a vertical structure which is formed from the Diffusion through a Contact (Con) connection to the first interconnection layer M1, i.e. "Diffusion-Con-M1". Similarly, another structure to connect the Gate through a Contact structure to the first interconnection layer M1 can be formed as "Gate-Con-M1". Additionally, if a connection structure is needed to be formed from the first interconnection layer M1 interconnection through a Via1 to connect to the second interconnection layer M2 interconnection, then it is named as "M1-Via1-M2". A more complex interconnection structure from the Gate-level to the second interconnection layer M2 can be described as "Gate-Con-M1-Via1-M2". Furthermore, a stacked interconnection system may have an "M1-Via1-M2-Via2-M3" or "M1-Via1-M2-Via2-M3-Via3-M4" structure, etc.

Since the Gate and the Diffusion in two access transistors (NMOS pass-gate transistors PG-1 and PG-2, as shown in FIG. 1) shall be connected to the word-line (WL) and/or bit-lines (BL and BL Bar) which will be arranged in the second interconnection layer M2 or the third interconnection layer M3, in traditional SRAM such metal connections must go through the first interconnection layer M1. That is, the state-of-the-art interconnection system in SRAM may not allow the Gate or Diffusion directly connect to second interconnection layer M2 without bypassing the M1 structure.

As results, the necessary space between one M1 interconnection and the other M1 interconnection will increase the die size and in some cases the wiring connections may block some efficient channeling intention of using M2 directly to surpass M1 regions. In addition, there is difficult to form a self-alignment structure between Via1 to Contact and at the same time both Via1 and Contact are connected to their own interconnection systems, respectively.

Additionally, in traditional 6T SRAM, at least there are one NMOS transistor and one PMOS transistor located respectively inside some adjacent regions of p-substrate and n-well which have been formed next to each other within a close neighborhood, a parasitic junction structure called n+/p/n/p+ parasitic bipolar device is formed with its contour starting from the n+ region of the NMOS transistor to the p-well to the neighboring n-well and further up to the p+ region of the PMOS transistor.

There are significant noises occurred on either n+/p junctions or p+/n junctions, an extraordinarily large current may flow through this n+/p/n/p+ junction abnormally which can possibly shut down some operations of CMOS circuits and to cause malfunction of the entire chip. Such an abnormal phenomenon called Latch-up is detrimental for CMOS operations and must be avoided. One way to increase the immunity to Latch-up which is certainly a weakness for CMOS is to increase the distance from n+ region to the p+ region. Thus, the increase of the distance from n+ region to the p+ region to avoid Latch-up issue will also enlarge the size of the SRAM cell.

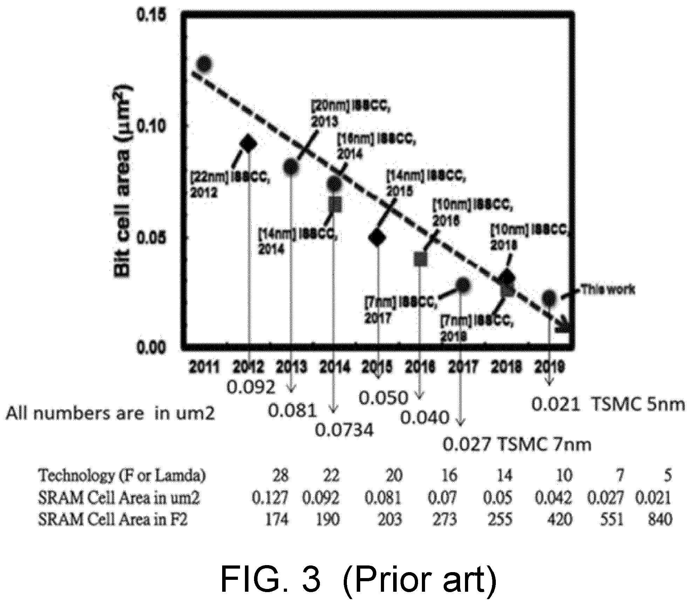

However, even miniaturization of the manufacture process down to the 28 nm or lower (so called, "minimum feature size", "Lambda (λ)", or "F"), due to the interference among the size of the contacts, among layouts of the metal wires connecting the word-line (WL), bit-lines (BL and BL Bar), high level voltage VDD, and low level voltage VSS, etc., the total area of the SRAM cell represented by λ² or F² dramatically increases when the minimum feature size decreases, as shown in FIG. 3 (cited from J. Chang et al., "15.1 A 5nm 135Mb SRAM in EUV and High-Mobility-Channel FinFET Technology with Metal Coupling and Charge-Sharing Write-Assist Circuitry Schemes for High-Density and Low-VMIN Applications," 2020 IEEE International Solid- State Circuits Conference - (ISSCC), 2020, pp. 238-240).

Similar situation happens to logic circuit scaling. Logic circuit scaling for increased storage density, reduction in operating voltage (Vdd) for lower stand-by power consumption, and enhanced yield necessary to realize larger-capacity logic circuit become increasingly difficult to achieve. Standard cells are commonly used and basic elements in logic circuit. The standard cell may comprise basic logical function cells (such as, inverter cell, NOR cell, and NAND cell.

Similarly, even miniaturization of the manufacture process down to the 28 nm or lower, due to the interference among the size of the contacts and layouts of the metal wires, the total area of the standard cell represented by λ² or F² dramatically increases when the minimum feature size decreases.

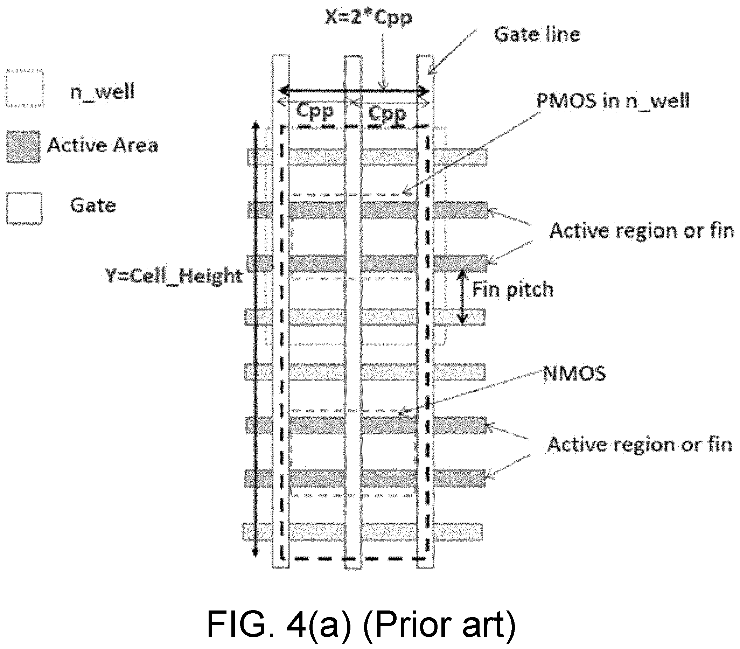

FIG. 4(a) shows the "stick diagram" representing the layout and connection among PMOS and NMOS transistors of one semiconductor company's 5nm (UHD) standard cell. The stick diagram just includes active regions (horizontal lines) and gate lines (vertical line). Hereinafter, the active region could be named as "fin". Of course, there are still lots of contacts, on one hand directly coupled to the PMOS and NMOS transistors, and on the other hand, coupled to the input terminal, the output terminal, high level voltage Vdd, and low level voltage VSS (or ground "GND"), etc. Especially, each transistor includes two active regions or fins (marked by grey dash rectangles) to form the channel of the transistor, such that the W/L ratio could be maintained within an acceptable range. The area size of the inverter cell is equal to X×Y wherein X=2×Cpp, Y=Cell_Height, Cpp is the distance of Contact to Poly Pitch(Cpp).

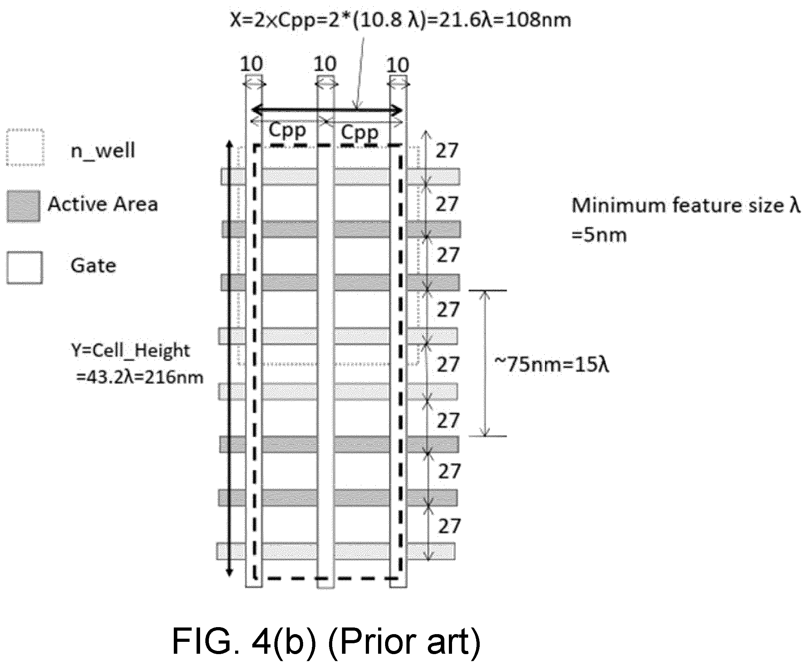

It is noticed that, some active regions or fins between PMOS and NMOS (called "dummy fins") are not utilized in PMOS/NMOS of this standard cell, the potential reason of which is likely related to the latch-up issue between the PMOS and NMOS. Thus, the latch-up distance between the PMOS and NMOS in FIG. 4(a) is 3×Fp, wherein Fp is the fin pitch. Based on the available data regarding Cpp (54nm) and cell Height (216 nm) in the 5nm standard cell, the cell area can be calculated by X×Y equal to 23328nm² (or 933.12λ², wherein Lambda (λ) is the minimum feature size as 5nm). Fig. 4(b) illustrates the aforesaid 5nm standard cell and the dimensions thereof. As shown in FIG. 4(b), the latch-up distance between PMOS and NMOS is 15λ, Cpp is 10.8λ, and cell Height is 43.2λ.

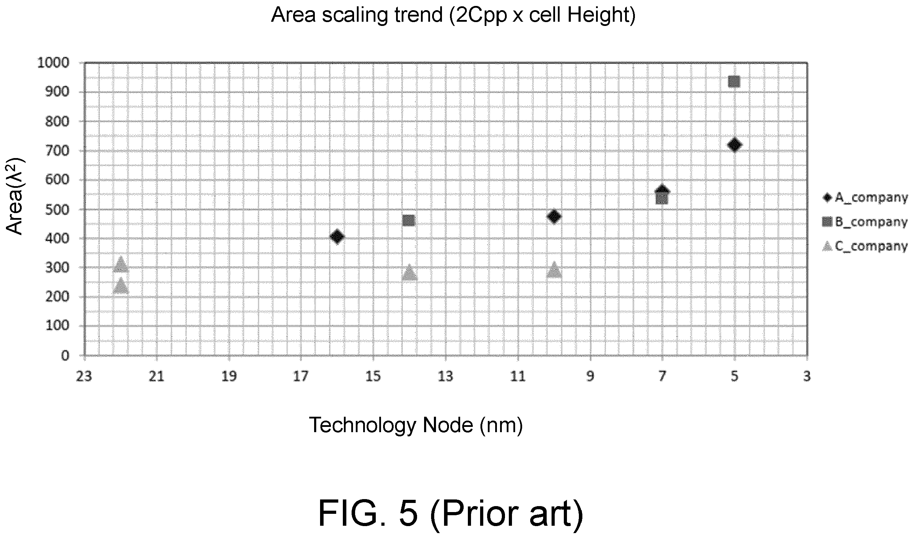

The scaling trend regarding area size (2Cpp × Cell_Height) v. different process technology node for three foundries could be shown in FIG. 5. As the technology node decreases (such as, from 22nm down to 5nm), it is clear that the conventional standard cell (2Cpp×Cell_Height) area size in term of λ² increases dramatically. In the conventional standard cell, the smaller the technology process node, the higher the area size in term of λ². Such dramatic increase λ², no matter in SRAM or logic circuit, may be caused by the difficulty to proportionally shrink the size of gate contact/source contact/drain contact as λ decreases, the difficulty to proportionally shrink the latch-up distance between the PMOS and NMOS, and the interference in metal layers as λ decreases, etc.

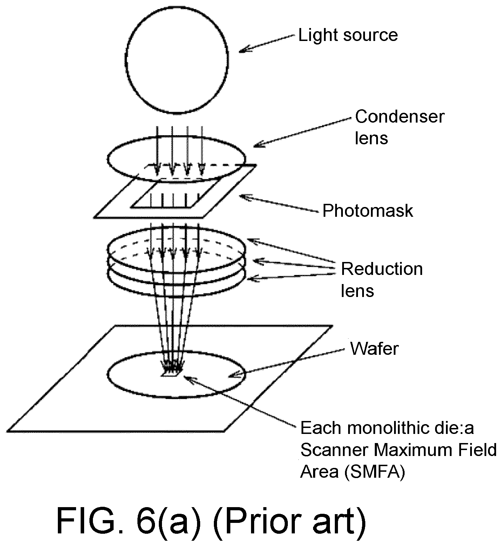

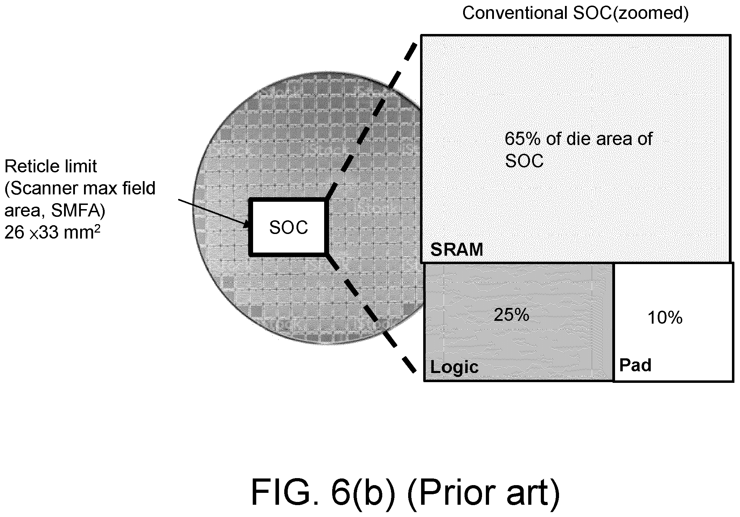

From another point of view, any high performance computing (HPC) chip, such as, SOC, AI, NPU (Network Processing Unit), GPU, CPU, and FPGA etc., currently they are using monolithic integration to put more circuits as many as possible. But, as shown in FIG. 6(a), maximizing die area of each monolithic die will be limited by the maximum reticle size of the lithography steppers which is hard to expand because of state-of-the-art existing photolithography exposure tools. For example, as shown in FIG. 6(b), current i193 and EUV lithography steppers have a maximum reticle size, thus, a monolithic SOC die has a scanner maximum field area (SMFA) of 26 mm by 33 mm, or 858 mm² (https://en.wikichip.org/wiki/mask). However, for high performance computing or AI purpose, the high-end consumer GPU seem to run in the 500-600 mm². As a result, it's getting harder or impossible to make two or more major function blocks such as GPU and FPGA (for example) on a single die. Also since the most widely used 6-Transistor CMOS SRAM Cells are quite large to increase the embedded SRAM (eSRAM) size enough for both major blocks, too. Additionally, the external DRAM capacity needs to be expanded, but the discrete PoP (Package on Package, eg. HBM to SOC) or POD (Package DRAM on SOC Die) is still constrained by difficulties of achieving desired performance of worse die-to-chip or package-to-chip signal interconnections.

Thus, there is a need to propose a new integration system including a logic chip with HPC and a SRAM chip with a high storage volume which could solve the above-mentioned problems such that more powerful and efficient SOC or AI single chip based on monolithic integration in the near future could come true.

### SUMMARY OF THE DISCLOSURE

One aspect of the present disclosure is to provide an IC package, wherein the package IC includes a substrate, a first monolithic die, a second monolithic die and a third monolithic die. A processing unit circuit is formed in the first monolithic die. A plurality of SRAM arrays are formed in the second monolithic die, wherein the plurality of SRAM arrays include at least 2-15G Bytes. A plurality of DRAM arrays are formed in the third monolithic die, wherein the plurality of DRAM arrays include at least 16-256G Bytes. The first monolithic die, the second monolithic die and the third monolithic die are vertically stacked above the substrate.

In one embodiment of the present disclosure, the first monolithic die has a die area the same or substantially the same as a scanner maximum field area defined by a specific technology process node; the second monolithic die has a die area the same or substantially the same as the scanner maximum field area defined by the specific technology process node; and the third monolithic die has a die area the same or substantially the same as the scanner maximum field area defined by the specific technology process node.

In one embodiment of the present disclosure, the scanner maximum field area is not greater than 26 mm by 33 mm, or 858 mm². In one embodiment of the present disclosure, the first monolithic die and the second monolithic die are enclosed within a single package; wherein the third monolithic die is electrically connected to the first monolithic die through the second monolithic die. In one embodiment of the present disclosure, the plurality of DRAM arrays include at least 128G Bytes, 256G Bytes or 512G Bytes.

In one embodiment of the present disclosure, the processing unit circuit comprising a first processing unit circuit and a second processing unit circuit, wherein the first processing unit circuit includes a plurality of first logic cores, and each of the plurality of first logic cores includes a first SRAM set; the second processing unit circuit includes a plurality of second logic cores, and each of the plurality of second logic cores includes a second SRAM set, wherein the first processing unit circuit or the second processing unit circuit is selected from a group consisting of a graphic processing unit (GPU), a central processing unit (CPU), a tensor processing unit (TPU), a network processing unit (NPU) and a field programmable gate array (FPGA).

In one embodiment of the present disclosure, the plurality of DRAM arrays include_a counter electrode on the top of the third monolithic die .

In one embodiment of the present disclosure, the processor IC further comprises a molding or shielding compound encapsulating the first monolithic die, the second monolithic die, and the third monolithic die, wherein a top surface of the counter electrode is revealed and not covered by the molding or shielding compound.

In one embodiment of the present disclosure, the processor IC further includes a top lead-frame contacted to the top surface of the counter electrode and the substrate; and a molding or shielding compound encapsulating the first monolithic die, the second monolithic die, the third monolithic die, and the top lead-frame.

Another aspect of the present disclosure is to provide an IC package, wherein the dual DRAM package includes a substrate; a first DRAM monolithic die and a second DRAM monolithic die. A first plurality of DRAM arrays are formed in the first DRAM monolithic die, wherein the first plurality of DRAM arrays include at least 16-256G Bytes, and the first plurality of DRAM arrays include a first counter electrode on the top portion of the first DRAM monolithic die. The second plurality of DRAM arrays are formed in the second DRAM monolithic die, wherein the second plurality of DRAM arrays include at least 16-256G Bytes; and the second plurality of DRAM arrays include a second counter electrode on the top portion of the second DRAM monolithic die. The first DRAM monolithic die and the second DRAM monolithic die are vertically stacked over the substrate; the second counter electrode of the second DRAM monolithic die is contacted to the substrate; and the first DRAM monolithic die is electrically connected to the substrate through the second DRAM monolithic die.

In one embodiment of the present disclosure, the second DRAM monolithic die is electrically coupled to the substrate through electrical bonding.

Another aspect of the present disclosure is to provide an integration system, wherein the integration system includes a carrier substrate, a first IC package, a second IC package and a metal shielding case. Wherein the first IC package is bonded to the carrier substrate; the second IC package is bonded to the carrier substrate; and the metal shielding case encapsulates the first IC package and the second IC package.

In one embodiment of the present disclosure, the integration system further includes a third IC package and a metal shielding case, wherein the third IC package is bonded to the carrier substrate; and the metal shielding case encapsulates the first IC package, the second IC package, and the third IC package.

In one embodiment of the present disclosure, the metal shielding case is thermally coupled to a first counter electrode on the top portion of the first DRAM monolithic die of the second IC package, and thermally coupled to a first counter electrode on the top portion of the first DRAM monolithic die of the third IC package.

### BRIEF DESCRIPTION OF THE DRAWINGS

The above and other aspects of the disclosure will become better understood with regard to the following detailed description of the preferred but non-limiting embodiment(s). The following description is made with reference to the accompanying drawings:
FIG. 1 is a schematic diagram for a regular 6T SRAM cell;
FIG. 2 is a stick diagram corresponding to the 6T SRAM in FIG. 1;
FIG. 3 is a diagram illustrating the total area of the SRAM cell in terms of λ² (or F²) for different process dimension λ (or F) according to the currently available manufacture processes;
FIG. 4(a) shows the "stick diagram" representing the layout and connection among PMOS and NMOS transistors of one semiconductor company's (Samsung) 5nm (UHD) standard cell;
FIG. 4(b) is the stick diagram illustrating the dimensions of the Samsung 5nm (UHD) standard cell as show in FIG. 4(a);
FIG. 5 illustrates the scaling trend regarding area size v. different process technology node for three foundries;
FIG. 6(a) and FIG. 6(b) are diagrams illustrating a monolithic SOC die with a scanner maximum field area (SMFA) which is limited by the maximum reticle size of the lithography steppers;
FIG.7(a) is a top view illustrating a mMOSFET used in a new standard cell according to one embodiment of the present disclosure;
FIG.7(b) is a cross-sectional view taken along the cutting line C7J1 as depicted in FIG.7(a);
FIG.7(c) is a cross-sectional view taken along the cutting line C7J 2 as depicted in FIG.7(a);
FIG. 8(a) is a top view illustrating a combination structure of the PMOS transistor and the NMOS transistor used in a new standard cell according to one embodiment of the present embodiment;
FIG.8(b) is a cross-sectional view of the PMOS transistor and the NMOS transistor taking along the cutline (X-axis) in FIG.8(a);
FIG. 9(a) is a diagram illustrating the SRAM bit cell size (in term of λ²) can be observed across different technology nodes from three different companies and the present invention;
FIG. 9(b) is a diagram illustrating the comparison result among the area size of the new standard cell provided by the preset invention and that of the conventional products provided by various other companies;
FIG. 10 is a diagram illustrating an integration system provided by an integrated scaling and stretching platform in comparison with a conventional one according to one embodiment of the present invention;
FIG. 11(a) is a diagram illustrating a single monolithic die of an integration system provided by the integrated scaling and stretching platform according to one embodiment of the present disclosure;
FIG. 11(b) is a diagram illustrating a single monolithic die of an integration system provided by the integrated scaling and stretching platform according to another embodiment of the present disclosure;
FIG. 11(c) is a diagram illustrating a single monolithic die of an integration system provided by the integrated scaling and stretching platform according to yet another embodiment of the present disclosure;
FIG. 11(d) is a diagram illustrating a single monolithic die of an integration system provided by the integrated scaling and stretching platform according to further another embodiment of the present disclosure;
FIG. 12(a) is a diagram illustrating an integration system provided by the integrated scaling and stretching platform in comparison with a conventional one according to yet another embodiment of the present disclosure;
FIG. 12(b) is a diagram illustrating the comparison results of the SRAM cell area among the integration system of the present invention and that of three foundries based on different technology nodes;
FIG. 13(a) is a diagram illustrating a single monolithic die of an integration system provided by the integrated scaling and stretching platform according to yet another embodiment of the present disclosure;
FIG. 13(b) is a diagram illustrating a single monolithic die of an integration system provided by the integrated scaling and stretching platform according to yet another embodiment of the present disclosure;
FIG. 14 is a diagram illustrating an integration system provided by the integrated scaling and stretching platform (ISSP) according to yet another embodiment of the present disclosure;
FIG. 15 is a schematic diagram illustrating an integration system provided by the integrated scaling and stretching platform (ISSP) according to yet another embodiment of the present disclosure;
FIG. 16 is a schematic diagram illustrating a traditional top-tier server processor;
FIG. 17 is a schematic diagram illustrating a server processor provided by the integrated scaling and stretching platform (ISSP) according to yet another embodiment of the present disclosure;
FIGs. 18(a)-18(f) are cross-sectional views illustrating a series of processing structures for fabricating an M-Cell according to one embodiment of the present discourse;
FIG. 19(a) is a schematic diagram illustrating a server processor provided by the integrated scaling and stretching platform (ISSP) according to yet another embodiment of the present disclosure;
FIG. 19(b) is a cross-sectional view illustrating the server processor as shown in FIG. 19(a);
FIG. 20 is a cross-sectional view illustrating a server processor according to yet another embodiment of the present disclosure;
FIG. 21 (a) is a diagram illustrating an ISSP rack server unit provided by the integrated scaling and stretching platform (ISSP) according to yet another embodiment of the present disclosure;
FIG. 21(b) is a cross-sectional view illustrating the rack server unit as shown in FIG. 21(a);
FIG. 22 is a diagram illustrating an ISSP rack server unit provided by the integrated scaling and stretching platform (ISSP) according to yet another embodiment of the present disclosure;
FIG. 23(a) is a diagram illustrating an ISSP rack server unit provided by the integrated scaling and stretching platform (ISSP) according to yet another embodiment of the present disclosure; and
FIG. 23(b) is a cross-sectional view illustrating the server processor as shown in FIG. 23(a).

### DETAILED DESCRIPTION OF THE DISCLOSURE

The present disclosure provides an integration system. The above and other aspects of the disclosure will become better understood by the following detailed description of the preferred but non-limiting embodiment(s). The following description is made with reference to the accompanying drawings:
Several embodiments of the present disclosure are disclosed below with reference to accompanying drawings. However, the structure and contents disclosed in the embodiments are for exemplary and explanatory purposes only, and the scope of protection of the present disclosure is not limited to the embodiments. It should be noted that the present disclosure does not illustrate all possible embodiments, and anyone skilled in the technology field of the disclosure will be able to make suitable modifications or changes based on the specification disclosed below to meet actual needs without breaching the spirit of the disclosure. The present disclosure is applicable to other implementations not disclosed in the specification.

### Embodiment 1

The disclosure has proposed to integrate the following inventions:
a. new transistors (presented in the US Patent Application No. 17/138,918, filed on Dec. 31, 2020 and entitled: "MINIATURIZED TRANSISTOR STRUCTURE WITH CONTROLLED DIMENSIONS OF SOURCE/DRAIN AND CONTACT-OPENING AND RELATED MANUFACTURE METHOD", and the whole content of the US Patent Application No. 17/138,918 is incorporated by reference herein; presented in the US Patent Application No. 16/991,044, field on August 12, 2020 and entitled "TRANSISTOR STRUCTURE AND RELATED INVERTER", and the whole content of the US Patent Application No. 16/991,044 is incorporated by reference herein; and presented in the US Patent Application No. 17/318,097, field on May 12, 2021 and entitled "COMPLEMENTARY MOSFET STRUCTURE WITH LOCALIZED ISOLATIONS IN SILICON SUBSTRATE TO REDUCE LEAKAGES AND PREVENT LATCH-UP", and the whole content of the US Patent Application No. 17/318,097 is incorporated by reference herein);
b. interconnection-to-transistor (presented in the U.S. Patent Application No. 17/528,481, filed on November 17, 2021 and entitled "MANUFACTURE METHOD FOR INTERCONNECTION STRUCTURE", and the whole content of the U.S. Patent Application No. 17/528,481 is incorporated by reference herein);
c. SRAM cell (presented in the U.S. Application No. 17/395,922, filed on August 6, 2021 and entitled "NEW SRAM CELL STRUCTURES", and the whole content of the U.S. Application No. 17/395,922 is incorporated by reference herein); and
d. Standard-Cell designs (presented in the U.S. Provisional Application No. 63/238,826, filed on August 31, 2021 and entitled "STANDARD CELL STRUCTURES", and the whole content of the U.S. Provisional Application No. 63/238,826 is incorporated by reference herein).

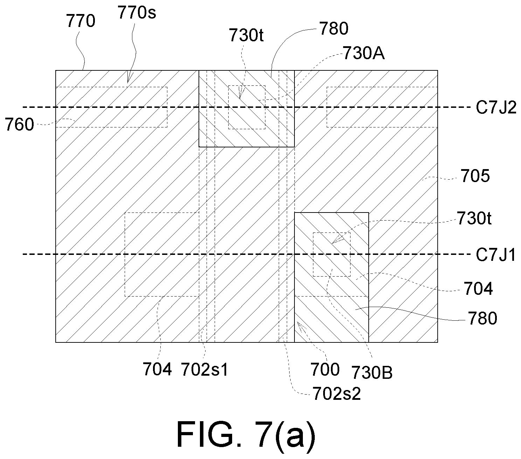

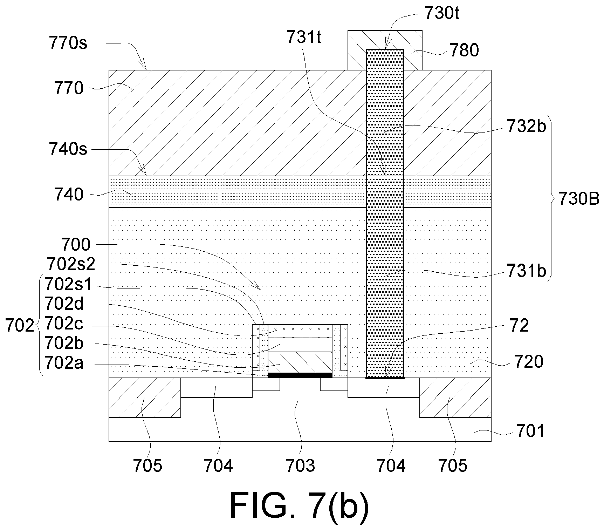

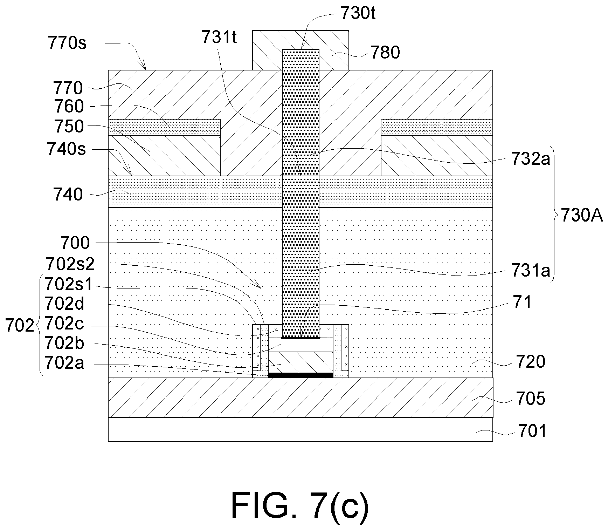

For example, FIG.7(a) is a top view illustrating a MOSFET structure according to one embodiment of the present disclosure. FIG.7(b) is a cross-sectional view taken along the cutting line C7J1 as depicted in FIG.7(a). FIG.7(c) is a cross-sectional view taken along the cutting line C7J 2 as depicted in FIG.7(a). In the proposed MOSFET, each the silicon region of the gate terminal (such as the silicon region 702c) and the silicon region of the source/drain terminal are exposed and has seed regions for the selective epitaxy growth technique (SEG) to grow pillars (such as a first conductor pillar portion 731a and a third conductor pillar portion 731b) based on the seed regions.

Furthermore, each of the first conductor pillar portions 731a and the third conductor pillar portion 731b also has a seed region or seed pillar in the upper portion thereof, and such seed region or seed pillar could be used for the following selective epitaxy growth. Subsequently, a second conductor pillar portion 732a is formed on the first conductor pillar 731a by a second selective epitaxy growth; and a fourth conductor pillar portion 732b is formed on the third conductor pillar portion 731b.

This embodiment, as shown in FIGs. 7(a)-7(c), could be applied to allows M1 interconnection (a kind of conductive terminal) or conduction layer to be directly connected to the MX interconnection layer (without connecting to the conduction layers M2, M3,..MX-1) in a self-alignment way through one vertical conductive or conductor plug, as long as there is a seed portion or seed pillar on the upper portion of the conductive terminal and the conductor pillar portions configured for following selective epitaxy growth technique. The seed portion or seed pillar is not limited to silicon, and any material which could be used as a seed configured for following selective epitaxy growth is acceptable.

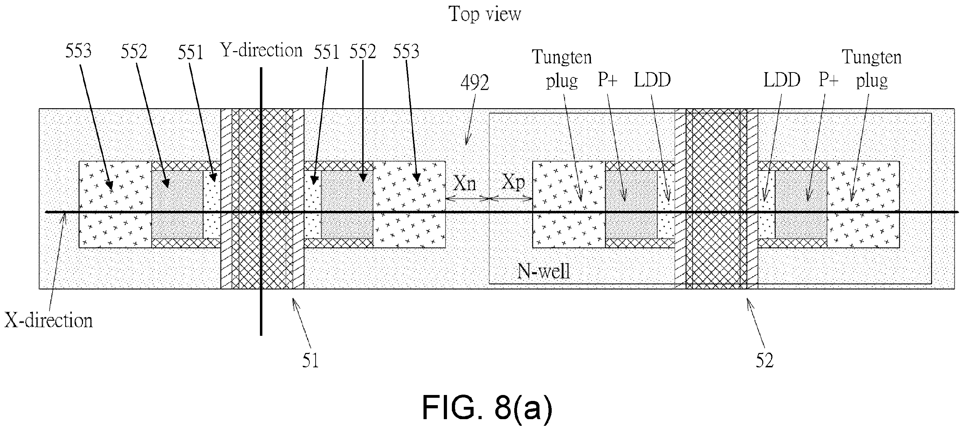

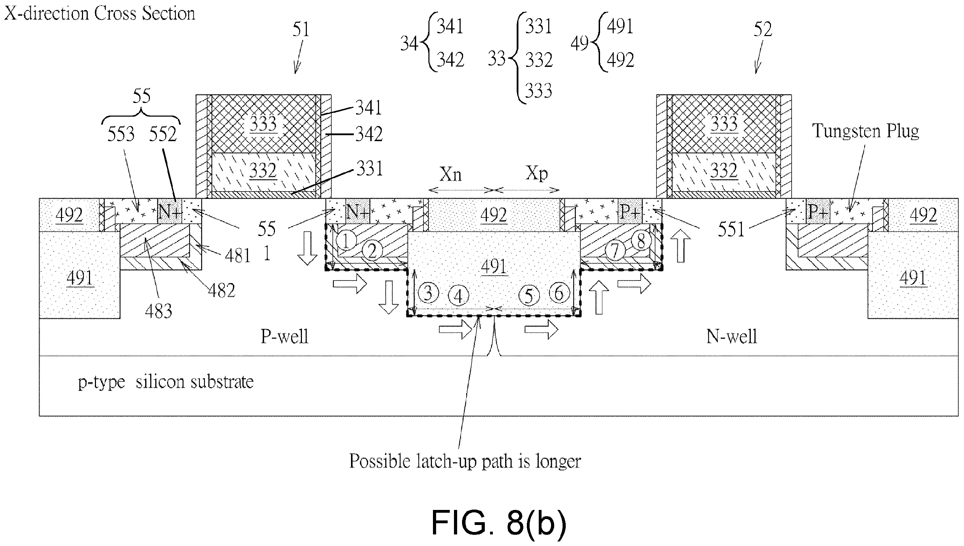

FIG. 8(a) is a top view illustrating a combination structure of the PMOS transistor 52 and the NMOS transistor 51 according to one embodiment of the present embodiment. FIG.8(b) is a cross-sectional view of the PMOS transistor 52 and the NMOS transistor 51 taking along the cutline (X-axis) in FIG.8(a). The structure of the PMOS transistor 52 is identical to that of the NMOS transistor 51. The gate structure 33 comprising a gate dielectric layer 331 and gate conductive layer 332 (such as gate metal) is formed above the horizontal surface or original surface of the semiconductor substrate (such as silicon substrate). A dielectric cap 333 (such as a composite of oxide layer and a Nitride layer) is over the gate conductive layer 332. Furthermore, spacers 34 which may include a composite of an oxide layer 341 and a Nitride layer 342 is used to over sidewalls of the gate structure 33. Trenches are formed in the silicon substrate, and all or at least part of the source region 55 and drain region 56 are positioned in the corresponding trenches, respectively. The source (or drain) region in the MOS transistor 52 may include N+ region or other suitable doping profile regions (such as gradual or stepwise change from P- region and P+ region).

Furthermore, a localized isolation 48 (such as nitride or other high-k dielectric material) is located in one trench and positioned under the source region, and another localized isolation 48 is located in another trench and positioned under the drain region. Such localized isolation 48 is below the horizontal silicon surface (HSS) of the silicon substrate and could be called as localized isolation into silicon substrate (LISS) 48. The LISS 48 could be a thick Nitride layer or a composite of dielectric layers. For example, the localized isolation or LISS 48 could comprise a composite localized isolation which includes an oxide layer 481 covering at least a portion sidewall of the trench and another oxide layer 482 covering at least a portion bottom wall of the trench. The oxide layers 481 and 482 could be L-Shape oxide layer formed by thermal oxidation process.

The composite localized isolation 48 could further include a nitride layer 483 being over the oxide layer 482 or/and the oxide layer 481. The shallow trench isolation (STI) region could comprise a composite STI 49 which includes a STI-1 layer 491 and a STI-2 layer 492, wherein the STI-1 layer 491 and a STI-2 layer 492 could be made of thick oxide material by different process, respectively.

Moreover, the source (or drain) region could comprise a composite source region 55 and/or drain region 56. For example, in the NMOS transistor 52, the composite source region 55 (or drain region 56) at least comprises a lightly doped drain (LDD) 551 and an N+ heavily doped region 552 in the trench. Especially, it is noted that the lightly doped drain (LDD) 551 abuts against an exposed silicon surface with a uniform (110) crystalline orientation. The exposed silicon surface has its vertical boundary with a suitable recessed thickness in contrast to the edge of the gate structure. The exposed silicon surface is substantially aligned with the gate structure. The exposed silicon surface could be a terminal face of the channel of the transistor.

The lightly doped drain (LDD) 551 and the N+ heavily doped region 552 could be formed based on a selective epitaxial growth (SEG) technique (or other suitable technology which may be Atomic Layer Deposition ALD or selective growth ALD-SALD) to grow silicon from the exposed TEC area which is used as crystalline seeds to form new well-organized (110) lattice across the LISS region which has no seeding effect on changing (110) crystalline structures of newly formed crystals of the composite source region 55 or drain region 56. Such newly formed crystals (including the lightly doped drain (LDD) 551 and the N+ heavily doped region 552) could be named as TEC-Si.

In one embodiment, the TEC is aligned or substantially aligned with the edge of the gate structure 33, and the length of the LDD 551 is adjustable, and the sidewall of the LDD 551 opposite to the TEC could be aligned or substantially aligned with the sidewall of the spacer 34. The composite source (or drain) region could further comprise some tungsten (or other suitable metal materials, such as TiN/Tungsten) plugs 553 formed in a horizontal connection to the TEC-Si portion for completion of the entire source/drain regions. The active channel current flowing to future Metal interconnection such as Metal-1 layer is gone through the LDD 551 and the N+ heavily-doped region 552 to tungsten 553 (or other metal materials) which is directly connected to Metal-1 by some good Metal-to-Metal Ohmic contact with much lower resistance than the traditional Silicon-to-Metal contact.

The source/drain contact resistance of the NMOS transistor 52 can be kept for a reasonable range according to the structure of the merged metal-semiconductor junction utilized in the source/drain structure. This merged metal-semiconductor junction in the source/drain structure can improve current crowding effect and reduce contact resistance. Additionally, because the bottom of source/drain structure is isolated from the substrate due to the bottom oxide (oxide layer 482), the n+ to n+ or p+ to p+ isolation can be kept within a reasonable range. Therefore, the spacing between two adjacent active regions of the PMOS transistor (not shown) could be scaled down to 2λ. The bottom oxide (oxide layer 482) can significantly reduce source/drain junction leakage current and then reduces n+ to n+ or p+ to p+ leakage current.

It results in a much longer path from the n+/p junction through the p-well (or p-substrate)/n-well junction to the n/p+ junction. As shown in FIG. 8(b), the possible Latch-up path from the LDD-n/p junction through the p-well /n-well junction to the n/LDD-p junction includes the length ①, the length ② (the length of the bottom wall of one LISS region), the length ③, the length ④, the length ⑤, the length ⑥, the length ⑦ (the length of the bottom wall of another LISS region), and the length ⑧ marked in FIG.8(b). Such possible Latch-up path is longer than that in a traditional CMOS structure. Therefore, from device layout point of view, the reserved edge distance (Xₙ+Xₚ) between the PMOS transistor 52 and the NMOS transistor 51 could be smaller than that in the traditional CMOS structure. For example, the reserved edge distance (Xₙ+Xₚ) could be around 2-4λ, such as 3λ.

Moreover, it is possible that the composite STI 49 is raised up (such as the STI-2 layer 492 is higher than the original semiconductor surface and up to the top surface of the gate structure, such that the selectively grown source/drain regions will be confined by the composite STI 49 and will not be over the composite STI 49. The metal contact plug (such as Tungsten plug 553) can be deposited in the hole between the composite STI 49 and the gate structure without using another contact mask to create a contact hole. Moreover, the top surface and one sidewall of the heavily-doped region 552 is directly contacted to the metal contact plug, and the contact resistance of the source/drain regions could be dramatically reduced.

Furthermore, in convention design, the metal wires for high level voltage Vdd and low level voltage Vss (or ground) are distributed above the original silicon surface of the silicon substrate, and such distribution will interfere with other metal wires if there no enough spaces among those metal wires. The present invention also discloses a new standard cell or SRAM cell in which the metal wires for high level voltage Vdd and/or the low level voltage Vss could be distributed under the original silicon surface of the silicon substrate, thus, the interference among the size of the contacts, among layouts of the metal wires connecting the high level voltage Vdd, and low level voltage Vss, etc. could be avoided even the size of the standard cell is shrunk.

For example, in the drain region of the NMOS 51, the tungsten or other metal materials 553 is directly coupled to, the P-well (by removing the LISS 48) which is electrically coupled to Vdd. Similarly, in the source region of the NMOS 51, the Tungsten or other metal materials 553 is directly coupled to the p-well or P-substrate (by removing the LISS 48) which is electrically coupled to ground. Thus, the openings for the source/drain regions which are originally used to electrically couple the source/drain regions with metal-2 layer (M2) or metal-3 layer (M3) for Vdd or ground connection could be omitted in the new standard cell and standard cell.

To sum up, at least there are following advantages:
(1) The linear dimensions of the source, the drain and the gate of the transistors in the standard cell/SRAM could be precisely controlled, and the linear dimension can be as small as the minimum feature size, Lambda (λ), as shown in the incorporated US Patent Application No. 17/138,918. Therefore, when two adjacent transistors are connected together through the drain/source, the length dimension of the transistor would be as small as 3λ, and the distance between the edges of the gates of the two adjacent transistors could be as small as 2λ. Of course, for tolerance purpose, the length dimension of the transistor would be around 3λ-6λ or larger, the distance between the edges of the gates of the two adjacent transistors could be 8λ or larger.
(2) The first metal interconnection (M1 layer) directly connect Gate, Source and/or Drain regions through self-aligned miniaturized contacts without using a conventional contact-hole-opening mask and/or an Metal-0 translation layer for M1 connections.
(3) The Gate and/or Diffusion (Source/Drain) areas are directly connected to the metal-2 (M2) interconnection layer without connecting the metal-1 layer (M1) in a self-alignment way. Therefore, the necessary space between one metal-1 layer (M1) interconnection layer and the other metal-1 layer (M1) interconnection layer and blocking issue in some wiring connections will be reduced. Furthermore, same structure could be applied to a lower metal layer is directly connected to an upper metal layer by a conductor pillar, but the conductor pillar is not electrically connected to any middle metal layer between the lower metal layer and the upper metal layer.
(4) The metal wires for high level voltage Vdd and/or the low level voltage VSS in the standard cell could be distributed under the original silicon surface of the silicon substrate, thus, the interference among the size of the contacts, among layouts of the metal wires connecting the high level voltage Vdd, and low level voltage Vss, etc. could be avoided even the size of the standard cell is shrunk. Moreover, the openings for the source/drain regions which are originally used to electrically couple the source/drain regions with metal-2 layer (M2) or metal-3 layer (M3) for Vdd or Ground connection could be omitted in the new standard cell and standard cell.

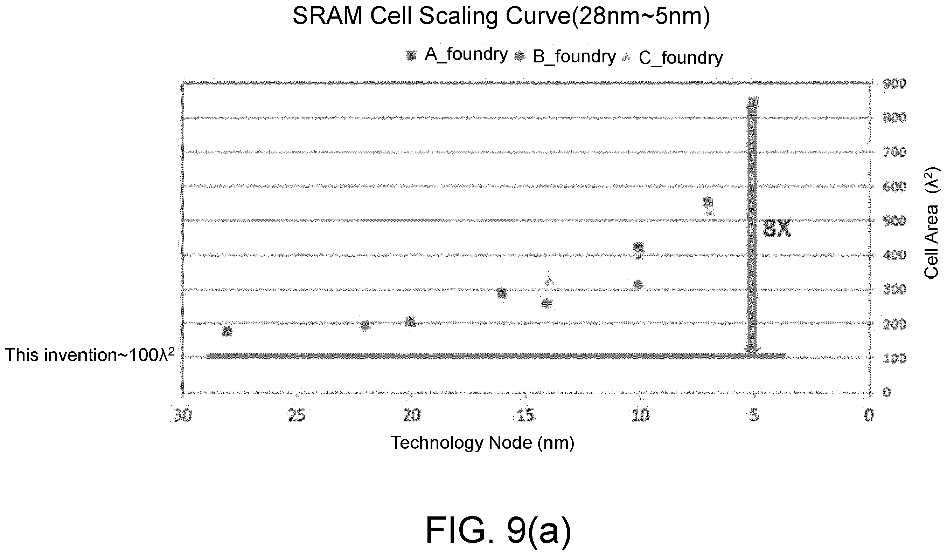

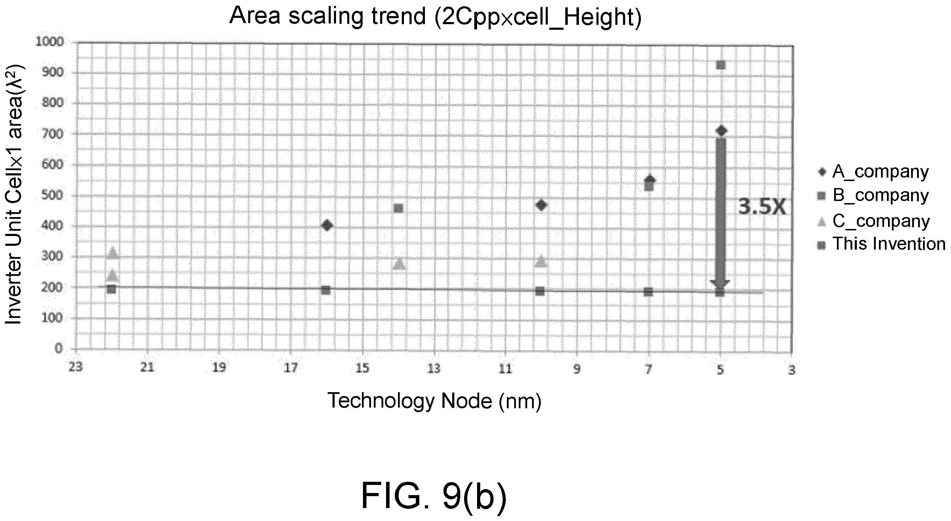

Based on the above-mentioned, FIG. 9(a) is a diagram illustrating the SRAM bit cell size (in term of λ²) can be observed across different technology nodes from three different companies and the present invention. FIG. 9(b) is a diagram illustrating the comparison result among the area size of the new standard cell provided by the preset invention and that of the conventional products provided by various other companies. As shown in FIG. 9(a), the area of the new proposed SRAM cell (the present invention) could be around 100λ², which is almost one eighth (1/8) of the area of the conventional 5nm SRAM cell (of three different companies) shown in FIG. 3. Moreover, as shown in FIG. 9(b), the area of the new proposed standard cell (such as inverter cell could be as smaller as 200λ²) is around 1/3.5 of the area of the conventional 5nm standard cell shown in FIG. 5.

Therefore, an innovation of an integrated scaling and/or stretching platform (ISSP) in its monolithic die design is proposed to provide an integration system, with any combination of the proposed technologies (such as, new transistor, interconnection-to-transistor, SRAM cell and standard-cell designs), such that an original schematic circuit of die that can be scaled down in its area by 2-3 times or more.

In another view, more SRAMs or more major different function blocks (CPU or GPU) could be formed in the original size of a single monolithic die. Thus, the device density and computing performance of an integration system (such as, an AI chip or SOC) can be significantly increased, in comparison with the conventional one having the same size, without shrinking the technology nodes for manufacturing the integration system.

Using 5 nm technology process node as example, a CMOS 6-T SRAM cell size can be shrunken to about 100 F² (where F is the minimum feature size made on silicon wafers) as shown in FIG.9(a). That is, if F = 5 nm, then the SRAM cell can occupy about 2500 nm² in contrast to the state-of-the-art cell area around 800 F² based on publications (i.e., shrunken by 8X). Moreover, an 8-finger CMOS Inverters (shown in FIG. 4(a) and 4(b)) should consume a die area of 200 F² based on the present invention, in contrast to that of the published conventional CMOS Inverter more than 700 F² (5 nm process node in FIG. 9(b)).

That is, in the event a single monolithic die has a circuit (such as a SRAM circuit, a logic circuit, a combination of a SRAM and a logic circuit, or a major function block circuit CPU, GPU, FPGA, etc.) which occupies a die area (such as Y nm²) based on a technology process node, with the help of the present invention, the total area of the monolithic die with the same schematic circuit could be shrunk, even the monolithic die is still manufactured by the same technology process node. The new die area occupied by the same schematic circuit in the monolithic die will be smaller than the original die area, such as be 20% to 80% (or 30% to 70%) of Y nm².

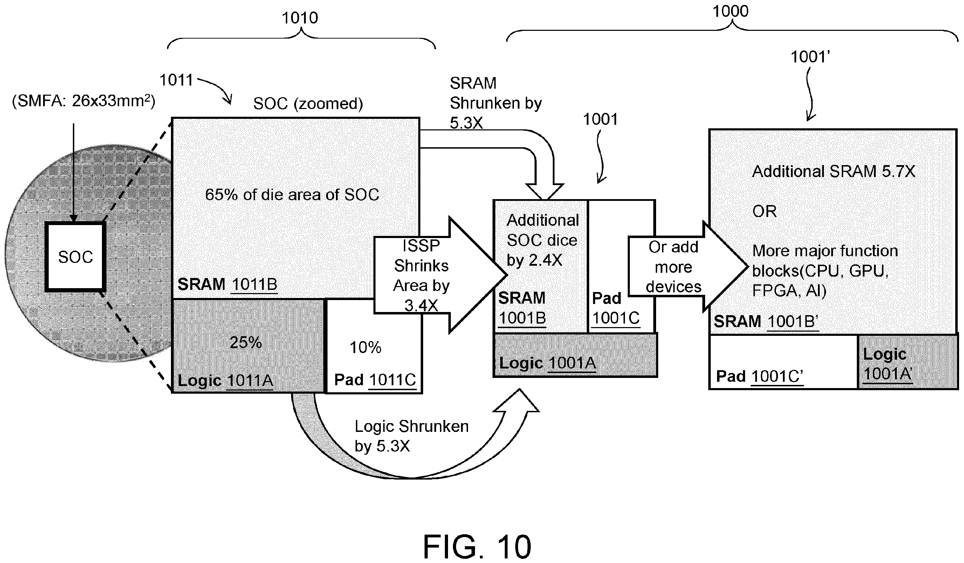

For example, FIG. 10 is a diagram illustrating an integration system 1000 based on an Integrated Scaling and Stretching Platform (ISSP) of the present invention in comparison with a conventional one. As illustrated in FIG. 10, the ISSP integration system 1000 and the conventional system 1010 includes at least one single monolithic die 1011 having at least one processing units/circuit or major function blocks (such as, a logic circuit 1011A and a SRAM circuit 1011B) and a pad region 1011C; and the integration system 1000 provided by the ISSP of the present invention also includes at least one single monolithic die 1001 having a logic circuit 1001A, a SRAM circuit 1011B and a pad region 1001C. By comparing the configurations of the monolithic dies 1011 and 1001 between the conventional system 1010 and the ISSP integration system 1000, it can be indicated that the ISSP of the present invention can either shrink the size of the integration system without deteriorating the conventional performance (the monolithic die 1001), or add more device within the same scanner maximum field area (the monolithic die 1001').

In one view of shrinking the size of the ISSP integration system 1000, as shown in the middle of FIG. 10, the single monolithic die 1001 of the ISSP integration system 1000 has the same circuits or major function blocks as the conventional monolithic die 1011(i.e., the logic circuit 1001A and the SRAM circuit 1010B of the single monolithic die 1001 are identical to the logic circuit 1011Aand the SRAM circuit 1011B of the single monolithic die 1011); and the single monolithic die 1001 just occupies 20%-80% (or 30%-70%) the scanner maximum field area of the conventional monolithic die 1011. I

In one embodiment, the combination area of the SRAM circuit 1001B and the logic circuit 1001A in the single monolithic die 1001 shrinks area by 3.4 times of area of the conventional monolithic die 1011. In other words, in comparison with the conventional monolithic die 1011, the ISSP of the present invention may lead the area the logic circuit 1001A of the single monolithic die 1001 shrunken by 5.3X; lead the area the SRAM circuit 1001B of the single monolithic die 1001 shrunken by 5.3X; and lead the combination area of the SRAM circuit 1001B and the logic circuit 1001A in the single monolithic die 1001 shrunken by 3.4X (as shown in the middle of FIG. 10).

In the another view of adding more devices, as shown in the right hand of FIG. 10, the single monolithic die 1001' and the conventional monolithic die 1011 have the same scanner maximum field area. That is, the single monolithic die 1001' is made based on the same technology node as that of the conventional monolithic die 1011 (such as, 5 nm or 7 nm), and the area of SRAM circuit 1001B' in the single monolithic die 1001' can not only include more SRAM cells, but can also include additional major function blocks not in the conventional monolithic die 1011. In another embodiment of the present disclosure, the die area of the single monolithic die 1001' (as shown in the right hand of FIG. 10) may be similar to or substantially the same as a scanner maximum field area (SMFA) of the conventional single monolithic die 1011 defined by a specific technology process node. That is, based on the ISSP of the present invention, in the scanner maximum field area (SMFA), there are addition space for accommodating additional SRAM cells or additional major function blocks other than that (the logic circuit 1011A and the SRAM circuit 1001B) included in the conventional monolithic die 1011.

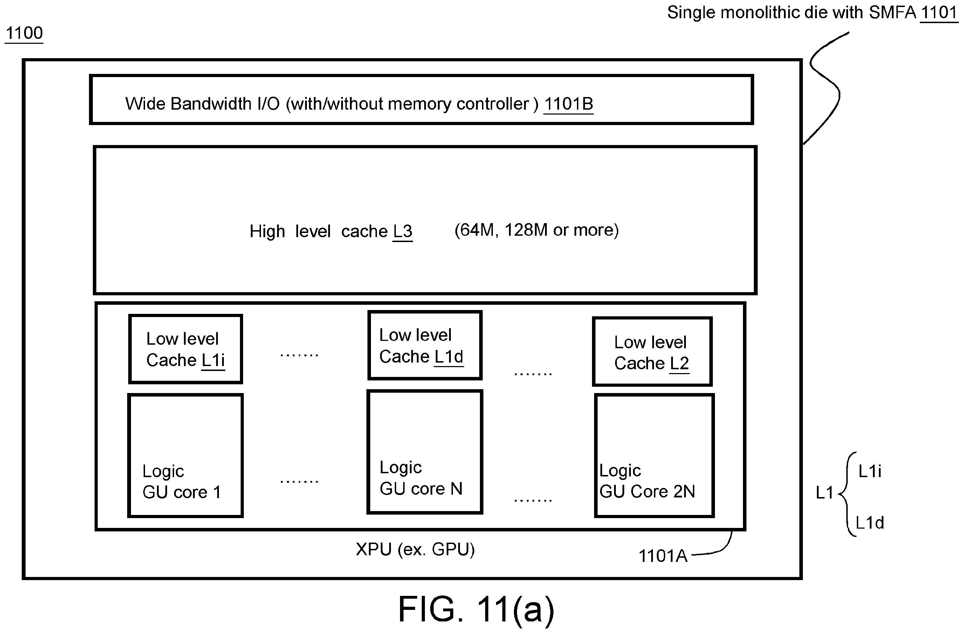

FIG. 11(a) is a diagram illustrating another ISSP integration system 1100 of the present disclosure. The ISSP integration system 1100 includes at least one monolithic die 1101 with size of SMFA. The monolithic die 1101 includes processing units/circuit (such as, a XPU 1101A), SRAM caches (including high level and low level caches), and an I/O circuit 1101B. Each of the SRAM cache includes a set of SRAM arrays. The I/O circuit 1101B is electrically connected to the plurality of SRAM caches and/or the XPU 1101A.

In the present embodiment, the monolithic die 1101 of the ISSP integration system 1100 includes different level caches L1, L2 and L3 commonly made of SRAMs. Wherein the caches L1 and L2 (collectively "low level cache") are usually allocated one per CPU or GPU core unit, with the cache L1 being divided into L1i and L1d, which are used to store instructions and data respectively, and the cache L2, which does not distinguish between instructions and data; and the cache L3 (could be one of "high level cache"), which is shared by multiple cores and usually does not distinguish between instructions and data either. The cache L1/L2 is usually one per CPU or GPU core.

For high speed operation, therefore, based on the ISSP of the present disclosure, the die area of the monolithic die 1101 may be the same or substantially the same as a scanner maximum field area (SMFA) defined by a specific technology process node. However, the storage volume of the cache L1/L2 (low level cache) and the cache L3 (high level cache) of the ISSP integration system 1100 could be increased. As shown in FIG. 11(a), a GPU with multiple cores has a SMFA (such as 26 mm by 33 mm, or 858 mm²) in which the high level cache could have 64MB or more (such as 128MB, 256 or 512MB) SRAM. Furthermore, additional logic cores of the GPU could be inserted into the same SMFA to enhance the performance. So is a memory controller (not shown) within the wide bandwidth I/O 1101B, for another embodiment.

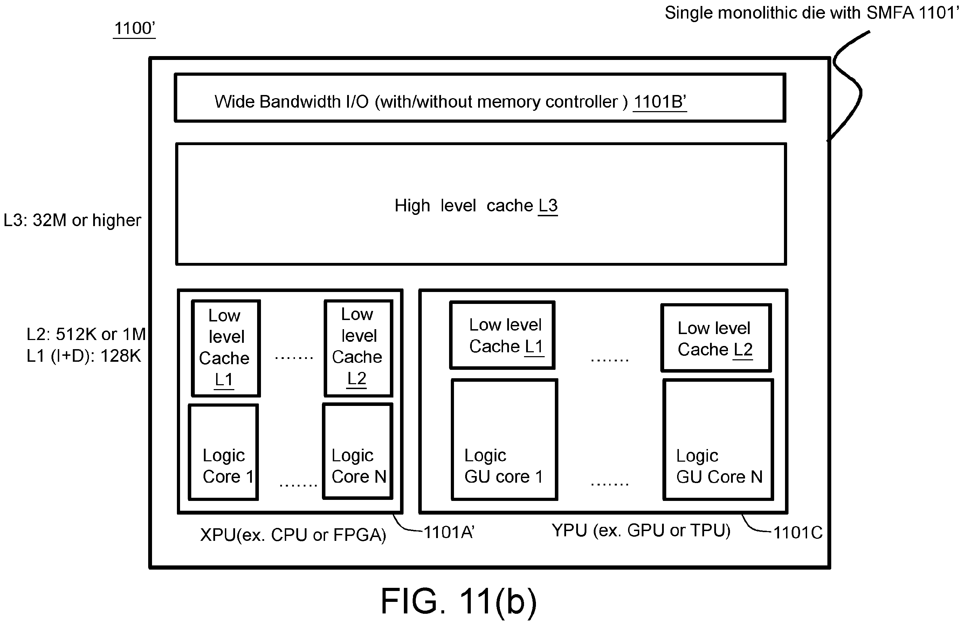

Alternatively, other than the exiting major function block, another different major function block, such as FPGA, can be integrated together in the same monolithic die. FIG. 11(b) is a diagram illustrating a single monolithic die 1101' of an ISSP integration system 1100' according to another embodiment of the present disclosure. In the present embodiment, the monolithic die 1101' includes at least one wide bandwidth I/O 1101B' and a plurality of processing units/circuits, such as a XPU 1101A' and a YPU 1101C. The processing units (the XPU 1101A' and the YPU 1101C) have major function blocks, and each of which could serve as a NPU, a GPU, a CPU, a FPGA, or a TPU (Tensor Processing Unit). The major function block of the XPU 1101a' could be different from that of the YPU 1101C.

For example, the XPU 1101A' of the ISSP integration system 1100' could serve as a CPU, and the YPU 1101C of the ISSP integration system 1100' could serve as a GPU. Each of the XPU 1101A' and the YPU 1101C has multiple logic cores, and each core has low level cache (such as cache L1/L2 with 512K or 1M/128K bits), and a high volume of high level cache (such as, cache L3 with 32MB, 64MB or more) shared by the XPU 1101A' and the YPU 1101C, and these three level caches may include a plurality of SRAM arrays respectively.

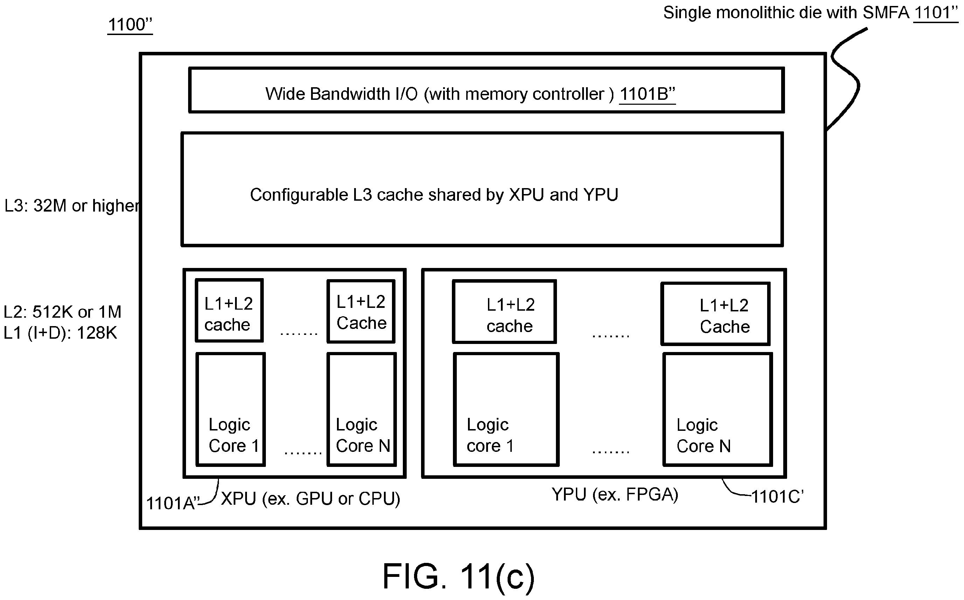

Due to the fact that a GPU is more and more critical for AI training, and FPGAs have blocks of logic that interact with each other and can be designed by engineers to help specific algorithms, and is suitable for AI inference. Thus, in some embodiments of the present disclosure, an ISSP integration system 1100" having a single monolithic die 1101" could include a GPU and a FPGA, as shown in FIG. 11(c). The configurations of the monolithic die 1101" in FIG. 11(c) is similar to that of the monolithic die 1101' of FIG. 11(b), except that the XPU 1101A" of the monolithic die 1101" is a GPU or a CPU, and the YPU 1101C' of the monolithic die 1101" is a FPGA. By this approach, the monolithic die 1101" on one hand has great parallel computing, training speed and efficiency, and on the other hand, it also owns great AI inference ability with faster time to market, lower cost, and flexibility.

In addition, as shown in FIG. 11(c), the processing units/circuits (i.e., the XPU 1101A" and the YPU 1101C') share the high level cache (such as, the cache L3). Wherein, the shared high level cache (such as the cache L3) between the 1101A" and the YPU 1101C' is configurable, either by setting in another mode register (not shown) or adaptively configurable during the operation of the monolithic die 1101". For example, in one embodiment, by setting the mode register, 1/3 of the high level cache could be used by the XPU 1101A", and 2/3 of the high level cache could be used by the YPU 1101C'. Such the shared volume of high level cache (such as, the cache L3) for the XPU 1101A" or the YPU 1101C' could also be dynamically changed based on the operation of the integrated scaling and/or stretching platform (ISSP) for forming the integration system 1100".

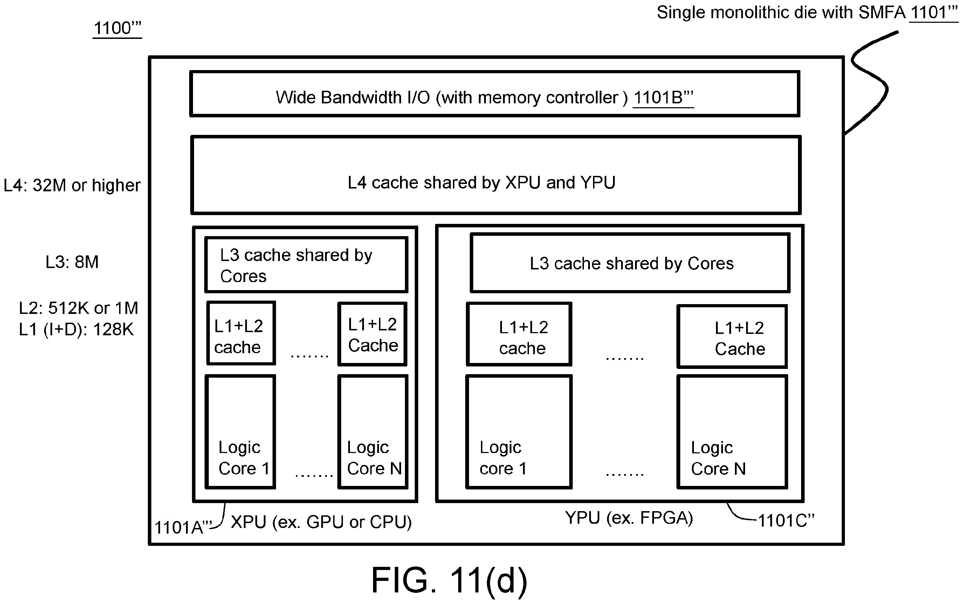

FIG. 11(d) is a diagram illustrating a single monolithic die 1101‴ of an ISSP integration system 1100‴ according to further another embodiment of the present disclosure. The arrangements of the monolithic die 1101‴ of FIG. 11(d) is similar to that of the monolithic die 1101' of FIG. 11(b), except that the high level cache includes caches L3 and caches L4, wherein each of the processing units/circuits (such as the XPU 1101A‴ and the YPU 1101C") has a cache L3 shared by its own cores, and the cache L4 with 32MB or more is shared by the XPU and the YPU.

In some embodiments of the present disclosure, somewhat larger capacity shared SRAM (or embedded SRAM, "eSRAM") can be designed into one monolithic (single) die due to smaller area of SRAM cell design according to the present invention. Since high storage volume of eSRAMs can be used, it's faster and effective, as compared with the conventional embedded DRAM or the external DRAMs. Thus, it is reasonable and possible to have a high bandwidth/high storage volume SRAM within a single monolithic die which has a die size the same or substantially the same (such as 80%-99%) as scanner maximum field area (SMFA, such as 26 mm by 33 mm, or 858 mm²).

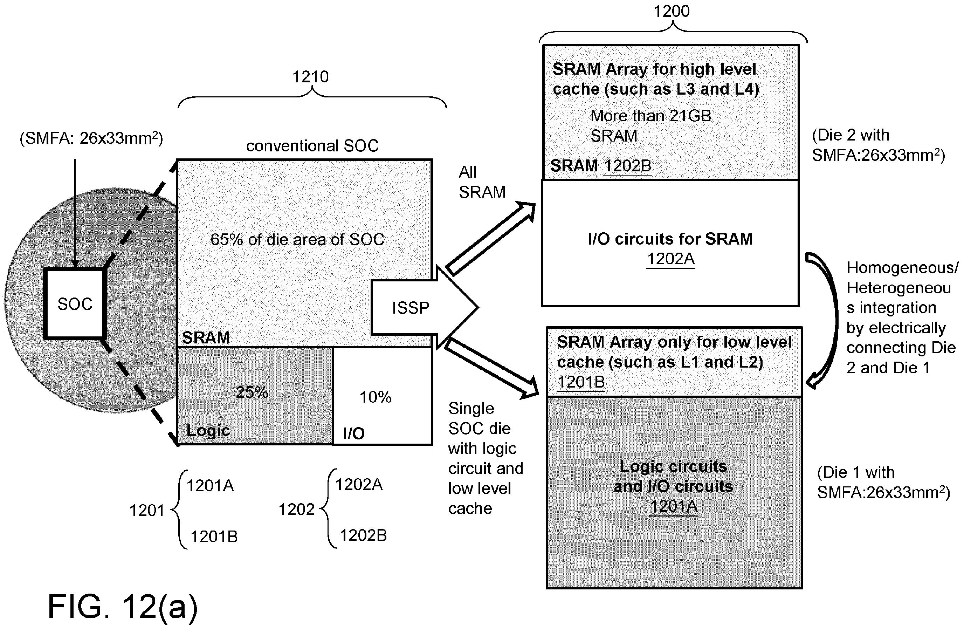

Therefore, the integration system 1200 provided by the integrated scaling and/or stretching platform (ISSP) of the present disclosure could include at least two single monolithic dies, and those two monolithic dies could have the same or substantially the same size. For example, FIG. 12(a) is a diagram illustrating another ISSP integration system 1200 in comparison with a conventional one 1210 according to yet another embodiment of the present disclosure. The ISSP integration system 1200 includes a single monolithic die 1201 and a single monolithic die 1202 within a single package. The single monolithic die 1201 majorly has a logic processing unit circuit and low level caches formed therein; and the second monolithic die 1202 just has a plurality of SRAM arrays and I/O circuits formed therein. Wherein the plurality of SRAM arrays include at least 2-20G Bytes, such as 2G-10G Bytes.

As shown in FIG. 12(a), the single monolithic die 1201 majorly includes a logic circuit and I/O circuit 1201A and small low level caches (such as L1 and L2 caches) made of SRAM array 1201B, and the single monolithic die 1202 just includes a high bandwidth SRAM circuit 1202B with 2-10G Bytes or more (such as 1-20G Bytes) and an I/O circuit 1202A for the high bandwidth SRAM circuit 1202B. In the present embodiment, the SMFA of the single monolithic die 1201 and the single monolithic die 1202 may be around 26 mm by 33 mm. Supposing 50% of the SMFA (50% SRAM cell utilization rate) of the single monolithic die 1202 is used for the SRAM cells of the high bandwidth SRAM circuit 1202B, and the rest of SMFA is used for the I/O circuit of the high bandwidth SRAM circuit 1202B.

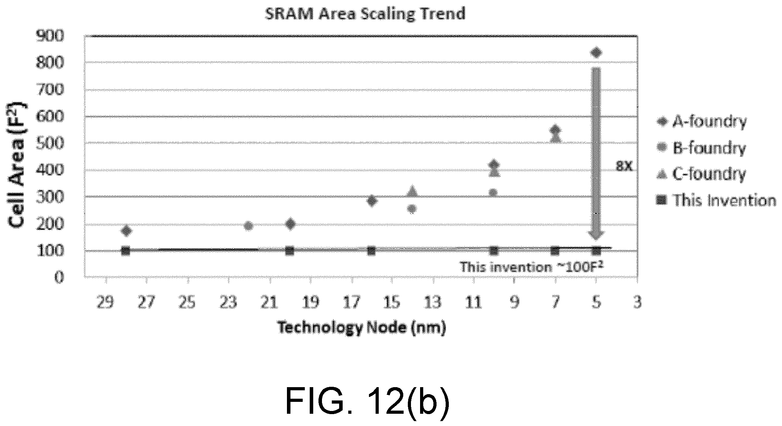

FIG. 12(b) is a diagram illustrating the comparison results of the SRAM cell area among the integration system 1200 of the present invention and that of three foundries based on different technology nodes. The total Bytes (one bit per SRAM cell) within the SMFA of 26 mm by 33 mm of one single monolithic die (such as, the single monolithic die 1202) can be estimated by reference with the SRAM cell area as shown in FIG. 12(b). For example, in the present embodiment, the SMFA (26 mm by 33 mm) of the single monolithic die 1202 could accommodate 21GB SRAM at technology node of 5 nm (the SRAM cell area is 0.0025 *µ*m²), and may provide 24GB or more, in the event SRAM cell utilization rate could be increased.

According to FIG. 12(b), since the conventional SRAM cell area (of the three foundries) could be 2-8 times of the SRAM cell area of the present invention, thus the ISSP integration system 1200 can accommodate more Bytes (one bit per SRAM cell) than that of the prior art within the SMFA of 26 mm by 33 mm. The total Bytes (one bit per SRAM cell) within the SMFA of 26 mm by 33 mm based on different technology nodes are shown in the following Table 1:

| Technology node | 5 | 7 | 10 | 14 | 16 |
|---|---|---|---|---|---|
| SRAM cell area(µm²) | 0.0025 | 0.0049 | 0.01 | 0.0196 | 0.0256 |
| bit/mm² | 4.00E + 08 | 2.04E + 08 | 1.00E + 08 | 5.10E+07 | 3.9E+07 |
| 26mm×33mm die (Byte) | 2.15E+10 | 1.09E+10 | 5.36E + 09 | 2.74E+09 | 2.09E+09 |

Of course, in consideration of selective usage of the different technologies proposed herein and the conventional Back End of Line technology, the SMFA (26 mm by 33 mm) of the single monolithic die 1202 may accommodate smaller volume of SRAM, such as 1/4-3/4 times SRAM size at different technology nodes in the above table 1. For example, the single monolithic die 1202 may accommodate around 2-15GB (such as, 5-15GB SRAM or 2.5GB-7.5GB), due to the selective usage of the different technologies proposed herein and the conventional Back End of Line technology.

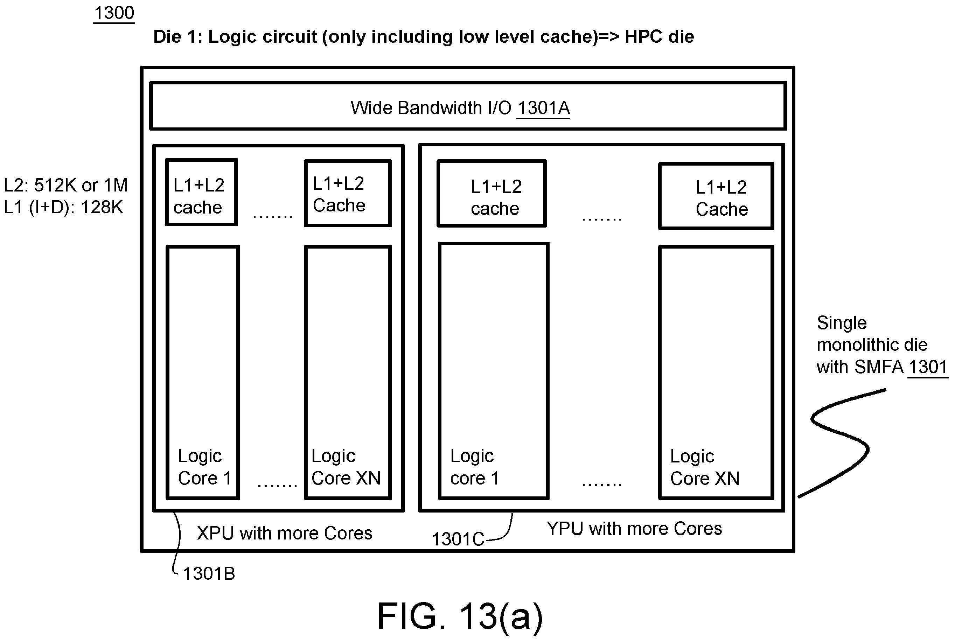

FIG. 13(a) is a diagram illustrating a single monolithic die 1301 of another ISSP integration system 1300 according to the present invention. The arrangements of the single monolithic die 1301 is similar to that of the single monolithic die 1201 of FIG. 12(a), except that the single monolithic die 1301 of the present embodiment can be a high performance computing (HPC) monolithic die that includes a wide bandwidth I/O circuit 1301A, two or more major function blocks, such as, a XPU 1301B and a YPU 1301C both with multiple cores, wherein each core of the XPU 1301B and the YPU 1301C has its own caches L1 and/or caches L2 (L1-128KB, and L2-512KB to 1MB). The major function block of the XPU 1301B or the YPU 1301C in FIG. 13(a) could be a NPU, a GPU, a CPU, a FPGA, or a TPU (Tensor Processing Unit), each of which has major function blocks. The XPU 1301B or the YPU 1301C may have different major function blocks.

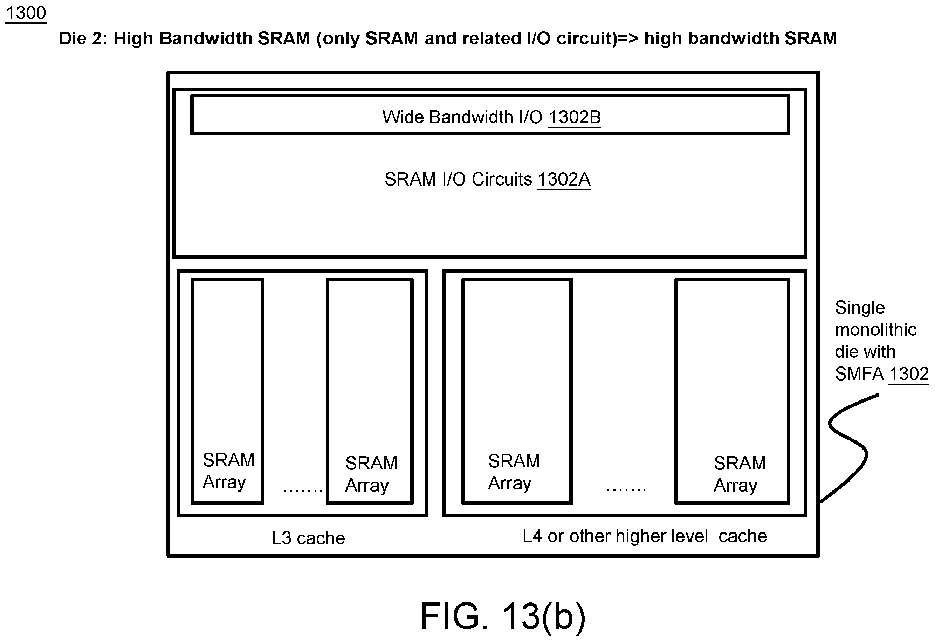

FIG. 13(b) is a diagram illustrating a single monolithic die 1302 of the ISSP integration system 1300. The arrangements of the single monolithic die 1302 is similar to that of the single monolithic die 1202 of FIG. 12(a), except that the single monolithic die 1302 is a high bandwidth SRAM (HBSRAM). In the present embodiment, the single monolithic die 1302 has a SMFA identical to (or with an area around 80-99% of) the state-of-the-art SMFA, and just includes caches L3 and/or L4 with multiple SRAM arrays, and a SRAM I/O circuits 1302A with a wide bandwidth 1302B I/O for the SRAM I/O circuits 1302A. The total SRAM in the single monolithic die 1302 could be 2-5GB, 5-10GB, 10-15GB, 15-20GB or more, depending on the utilization rate of the SRAM cells. Such single monolithic die 1302 could be a high bandwidth SRAM (HBSRAM).

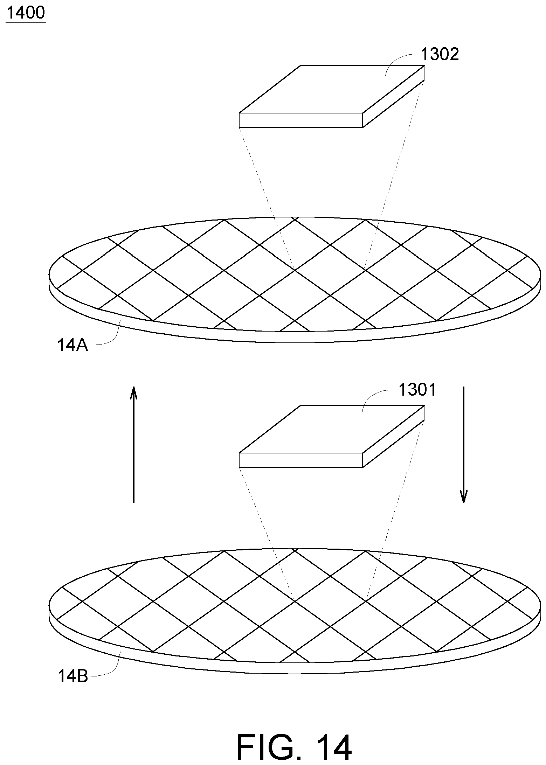

As shown in FIGs. 13(a) and 13(b), each of the single monolithic die 1301 and the single monolithic die 1302 has a wide bandwidth I/O bus, such as 64bit, 128bits or 256bits data bus. The single monolithic die 1301 and the single monolithic die 1302 could be in the same IC package or in different IC package. For example, in some embodiments, the single monolithic die 1301 (such as, the HPC die) could be bonded (such as, by wire bonding, flip chip bonding, solder bonding, 2.5D interpose through silicon via (TSV) bonding, 3D micro cupper pillar direct bonding) to the single monolithic die 1302 and enclosed in a single package to form an integration system 1400, as shown in FIG. 14. In the embodiment, both the single monolithic die 1301 and the single monolithic die 1302 have the same or substantially the same SMFA, thus, such bonding could be finalized by directly bonding a wafer 14A at least having the single monolithic die 1301 (or with multiple dices) to another wafer 14B at least having the single monolithic die 1302 (or with multiple dices), and then slices the bonded wafers 14A and 14B into multiple SMFA blocks to form a the integration system 1400 provided by the ISSP of the present disclosure. It is possible that another interpose with TSV could be inserted between the single monolithic die 1301 and the single monolithic die 1302.

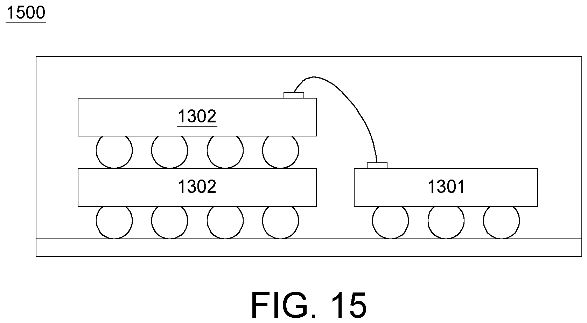

FIG. 15 is a diagram illustrating another ISSP integration system 1500 according to the present disclosure. The integration system 1500 includes two or more single monolithic die 1302 (that is two HBSRAM dies as shown in FIG. 13(b)) bonded together, and one of the two single monolithic die 1302 is then bonded to the single monolithic die 1301 (such as, the HPC die as shown in FIG. 13(a)), then all three or more dices are enclosed in a single package. Thus, such package could include a HPC die and more than 42, 48, or 96GB HBSRAM. Of course, those two or more single monolithic die 1302 and the single monolithic die 1301 with wide bandwidth I/O bus could be vertically stacked and bonded together based on the state-of-the-art bonding technology.

Of course, it is possible three, four or more HBSRAM dices can be integrated in a single package of the integration system 1500, then the caches L3 and L4 in the integration system 1500 could be more than 128 GB or 256GB SRAM. In some embodiments of the present disclosure, the single monolithic dies 1301 and 1302 of the integration system 1500 could be enclosed in the same IC package.

Comparing with currently available HBM DRAM memory which includes around 24GB based on the stack of 12 DRAM chips, the present invention could replace the HBM3 memory by more HBSRAM (such as one HBSRAM chip with around 5-10GB or 15-20GB). Therefore, no HMB memory or only few HBM memory (such as less than 4GB or 8GB HBM) is required in the ISSP.

The application of the integration system provided by the integrated scaling and stretching platform (ISSP) of the present invention is not limited to these regards as discussed above, the ISSP can be also applied to form integration system with DRAM cell structure, such as a rack server having DRAM Dual In-line Memory Modules (DRAM DIMMs).

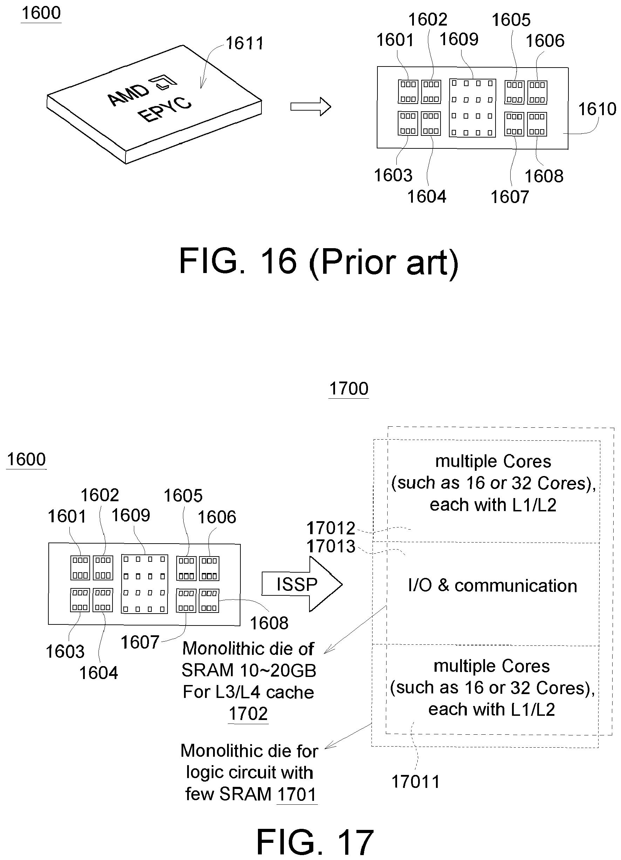

Nowadays, rack servers are commonly used for data center and cloud computing application. Each rack server may include one or two top-tier server processors and 4-8 memory slots for inserting DRAM DIMMs. A traditional top-tier server processor 1600, such as a AMD 3^{rd} generation EPYC^{™} processor as shown in FIG. 16, may include up to 64 processing cores and other circuits (e.g., an I/O die with security, communication circuits), wherein there are 9 packaged ICs (including eight processing chips with 8~64 cores 1601-1608 and one logic die with I/O, security, communication circuits 1609) landed on a PCB board 1610 and then encapsulated by a shielding metal case 1611. Each core of the top-tier server processor 1600 may have corresponding 32MB L3 caches.

However, the distance between the server processor 1600 and the DIMM slots on the motherboard of the rack server may be 3-10cm, the operation frequency for the server processor may up to 3.5G-4G Hz and the operation frequency for the DDR 5 may be up to 4.8 GHz. Therefore, the signal propagation distortion and EMI issues in such rack server are always challenging problems.

The problems can be solved by applying the integrated scaling and stretching platform (ISSP) of the present invention, as previously mentioned in FIGs. 12(a) and 13(a)-13(b) to form the rack server, wherein a single monolithic die which comprises high bandwidth SRAM with 2-20GB (such as 2-4GB, 5GB-10GB, 15-20GB, etc.) or more could be available according the aforesaid disclosure. Another single monolithic die which comprises logic circuits (such as XPU and YPU; or more than 32 or 64 cores), I/O circuit and a few L1 and L2 level caches is available as well. For example, FIG. 17 is a schematic diagram illustrating a server processor (e.g. a rack server) 1700 provided by the integrated scaling and stretching platform (ISSP) according to yet another embodiment of the present disclosure.

In the present embodiment, a single monolithic die 1701 includes processing chips 17011&17012 each of which may includes16 or 32 cores (each with L1/L2 caches), and other circuits 17013 (e.g., I/O, security, communication circuits) originally arranged in the top-tier server processor 1600 can also be integrated in a single monolithic die 1701; and 2-5GB (or 5-10GB, or 10GB -15GB) L3/L4 SRAM caches originally arranged in the top-tier server processor 1600 can be integrated in a second single monolithic die 1702.

Thus, the 9 separate packaged ICs originally arranged in the up-to-date server processor (AMD 3^{rd} generation EPYC^{™} processor) 1600 could be transformed into two the separate monolithic dies 1701 and 1702 based on ISSP proposed by this invention, wherein one single monolithic dies 1701 have 32-64 processing cores, L1/L2 SRAM caches and other circuits (e.g., I/O, security, communication circuits), and the monolithic die 1702 has 2-5GB (or 5-10GB, or 10GB -15GB) or more L3/L4 SRAM caches, as shown in FIG. 17.

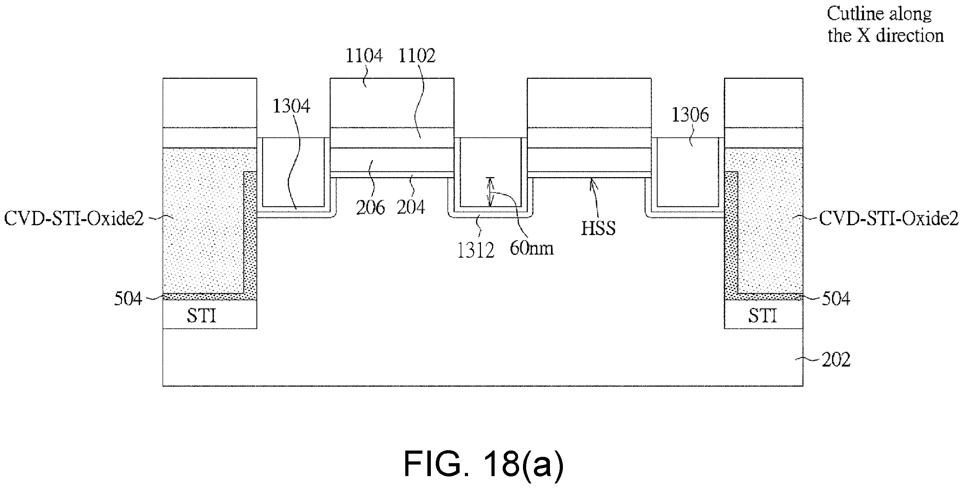

Moreover, a new DRAM cell structure ("M-Cell 1800") base on the integrated scaling and stretching platform (ISSP) of the present invention is disclosed, the area of which could be as small as 4-6λ² or 4-10λ². FIGs. 18(a)-18(f) are cross-sectional views illustrating a series of processing structures for fabricating the M-Cell 1800 according to one embodiment of the present discourse. The forming of the M-Cell 1800 includes steps as follows:

Firstly, word lines and the gate structures (including a high-k insulator layer 1304 and a gate material 1306) of a plurality of access transistors AQ1, AQ2 and AQ3 are formed in U-shaped concaves of horizontal silicon surface (hereinafter, "HSS") of the substrate 202. As shown in FIG. 18(a), the horizontal semiconductor surface (HSS) or original semiconductor surface (OSS) exposed at the cross-point squares is etched by the anisotropic etching technique to create the concave (such as U-shape), wherein the U-shaped concave is for a U-shaped channel 1312 of the access transistor, and for example, a vertical depth of the U-shaped concave can be around 60nm from the HSS. Since the U-shaped concave of the access transistor is exposed, a channel doping design can be achieved by somewhat well-designed boron (p-type dopant) concentration to dope the U-shaped channel 1312 of the U-shaped concave for a desired threshold voltage of the access transistor after a subsequent high-k metal-gate structure formation.

The suitable high-k insulator layer 1304 is formed as a gate dielectric layer of the access transistor, wherein a top of two edges of the high-k insulator layer 1304 could be higher than the HSS. Afterwards select a suitable gate material 1306 that is appropriate for a word line conductance and can achieve a targeted work-function performance for the access transistor to have a lower threshold voltage (a goal of selecting the suitable gate material 1306 is to reduce a boosted word line voltage level to be as low as possible but provide sufficient device drive in completing enough amount of charges to be restored into the capacitor and, on the other hand, in facilitating faster charge transfer for signal sensing).

The gate material 1306 is thick enough to fill in the U-shape concaves between two adjacent longitudinal stripes (the oxide-3 layer 1102 and the nitride-2 layer 1104). Then, the gate material 1306 is etched back to result in a longitudinal (the Y direction) word line which is sandwiched between two adjacent longitudinal stripes (the oxide-3 layer 1102 and the nitride-2 layer 1104). The newly proposed access transistor (hereafter called as U-transistor) with the U-shaped channel 1302 is different from a recessed transistor commonly used in the state-of-the-art buried word line design. The U-transistor has its body with two sides bounded by the CVD-STI-oxide2 along the Y direction (i.e. a channel width direction) and its channel length including a depth of one edge of the U-shaped channel 1312 on a side corresponding to a drain of the U-transistor, a length of a bottom of the U-shaped channel 1312, and a depth of another edge of the U-shaped channel 1312 on a side corresponding to a source of the U-transistor.

Due to a structure difference between the U-transistor and the recessed transistor, the channel length of the U-transistor can be much better controlled. In addition, since the HSS is fixed, the dopant concentration profiles of the drain and the source of the U-transistor, respectively, are much more controllable with less device-design-parameter variations as revealed more clearly as to be described later about how to complete the drain and the source of the U-transistor. In addition, forming simultaneously the gate structure of the U-transistor and the word line in the longitudinal direction by self-alignment between the two adjacent longitudinal stripes (the oxide-3 layer 1102 and the nitride-2 layer 1104) is such a way that the word line is not below the HSS, wherein that the word line is not below the HSS presents quite different design and performance parameters from the commonly used buried word line. In addition, a height of the word line (i.e. the gate material 1306) is designed to be lower than that of the composite layers (composed of the oxide-3 layer 1102 and the nitride-2 layer 1104) by using the etching-back technique (shown in FIG. 18(a)).

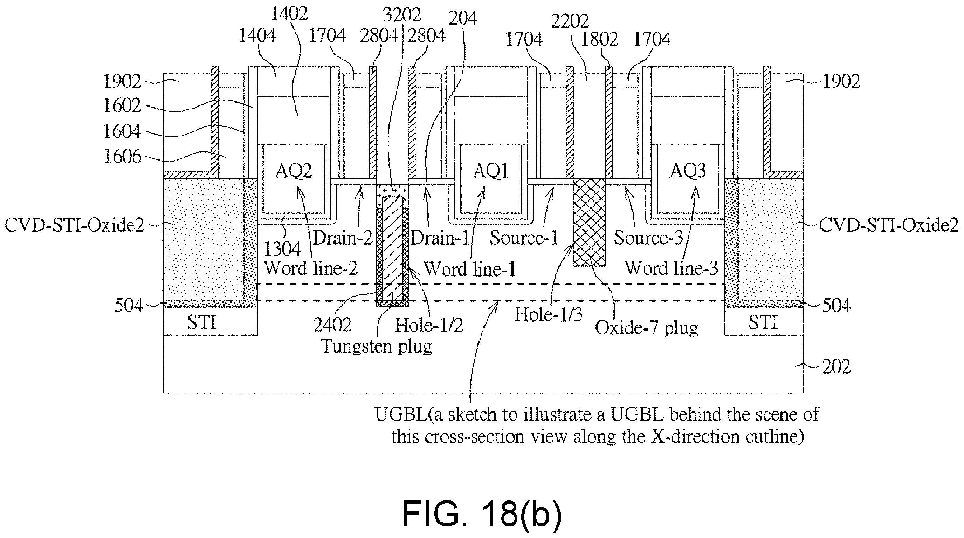

Next, an oxide-7 plug made of oxide-7 layer is formed in the hole-1/3 that is formed in the center of the source region below the HSS-1/3; a tungsten plug made of a metal layer 2802 is formed inside the hole-1/2 that is formed in the drain region to connect with the UGBL (Underground Bit line which is below the HSS); and a necklace-type conductive n+ silicon 3202 (named as n+ silicon drain-collar) connecting to the HSS on two sides of the hole-1/2 as the drain-1 and the drain-2 of the access transistors AQ1, AQ2, respectively, and also as a conductive bridge (i.e. bridge contact) between the UGBL and the access transistors AQ1, AQ2(as shown in FIG. 18(b)).

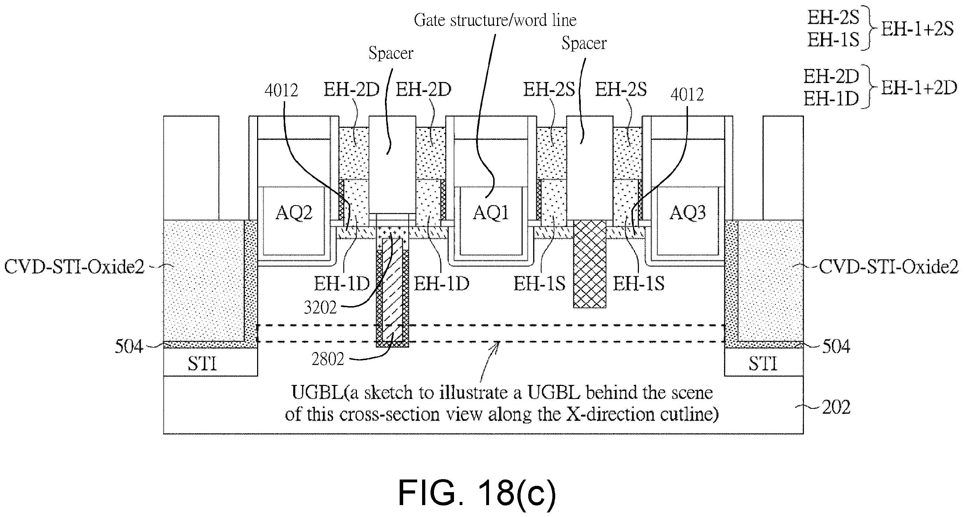

Elevated source electrodes EH-1S and elevated drain electrodes EH-1D are respectively formed in a vertical direction above the HSS by a selective epitaxy silicon growth technology, using the exposed HSS as the seed; and elevated source electrodes EH-2S and elevated drain electrodes EH-2D are respectively formed by carrying out another selective epitaxial silicon growth process using the exposed silicon surfaces of the source electrode EH-1S and the drain electrode EH-1D as high-quality silicon seeds (as shown in FIG. 18(c)).

The elevated source electrode EH-1S and the elevated drain electrode EH-1D could be the pure silicon material rather than polycrystalline or amorphous silicon materials since they are well grown gradually by using the exposed HSS) as the seed. Both the elevated source electrode EH-1S and the elevated drain electrode EH-1D are surrounded by gate structure/wordline and the oxide-5 spacer on the left sidewall and the right sidewall along the X-direction. Although the other two sidewalls along the Y-direction are widely opened, the CVD-STI-oxide2 cannot provide the seeding function for growing up the selective epitaxial silicon and therefore the selective epitaxy silicon growth should result in having some laterally over-grown pure-silicon materials which stop on the edges of CVD-STI-oxide2 and have no possibility of causing connections of the neighboring electrodes. In addition, after the elevated source electrode EH-1S and the elevated drain electrode EH-1D are grown, an optional RTA (rapid temperature annealing) step can be utilized to form NLDD (n+ lightly doped drain) 4012 under the elevated source electrode EH-1S or the elevated drain electrode EH-1D, such that the elevated source electrode EH-1S or the elevated drain electrode EH-1D has better electrical connection to channel region of the transistor.

During the selective epitaxial silicon growth process for growing the elevated source electrodes EH-2S and the elevated drain electrodes EH-2D, a well-designed heavier in-situ n+ doping concentration can be achieved in the elevated source electrode EH-2S and the elevated drain electrode EH-2D in order to be prepared for a low-resistivity connection between the elevated source electrode EH-2S (or the elevated drain electrode EH-2D) and the storage electrode of the stacked storage capacitor (SSC) which will be made later. The combination of the elevated source electrode EH-1S and the elevated source electrode EH-2S is called as the elevated source electrode EH-1+2S (similarly, the combination of the elevated drain electrode EH-1D and the elevated drain electrode EH-2D is called as the elevated drain electrode EH-1+2D). In addition, taking the elevated source electrode EH-1+2S as an example, the upper portion of the elevated source electrode EH-1+2S, i.e. the elevated source electrode EH-2S, has some high-quality, n+ doped silicon material directly abutted to the spacer on one sidewall and the opposite sidewall is close to gate structure/wordline, and the other two sidewalls are widely open on the Y-direction along the longitudinal word line. The height of the elevated source electrode EH-1+2S (the height of the elevated drain electrode EH-1+2D) is well designed to be lower than that of the spacer.

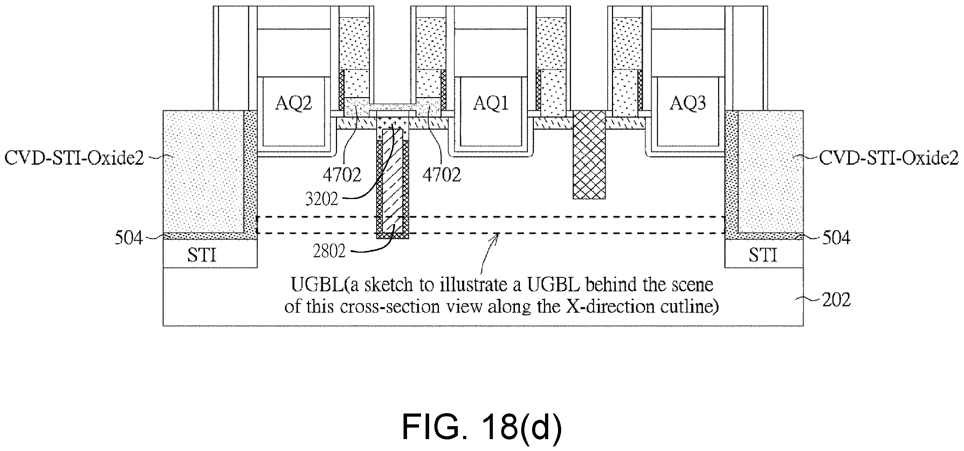

As shown in FIG. 18(d), an oxide isolation layer (a portion of the high-quality oxide-bb layer 4702) is then formed to well isolate the drain region away from the bottoms of the EH-1+2D electrodes that can now be used as part of the storage electrode for the storage capacitor.

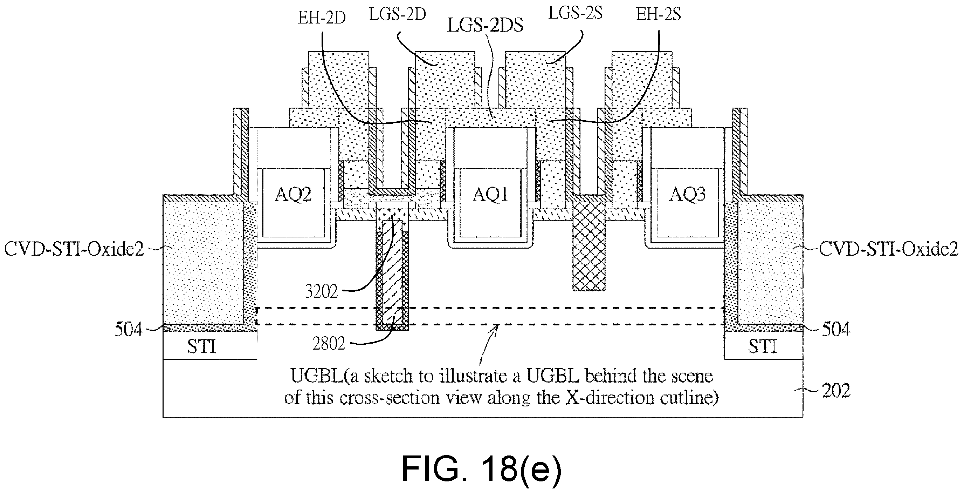

As shown in FIG. 18(e), a LGS-2D and a LGS-2S region are respectively formed on the drain side and the source side by selective growth technique based on the elevated source electrode EH-2S and the elevated drain electrode EH-2D. Moreover, a LGS-2DS region is also formed by selective growth technique to connect the LGS-2D and a LGS-2S region.

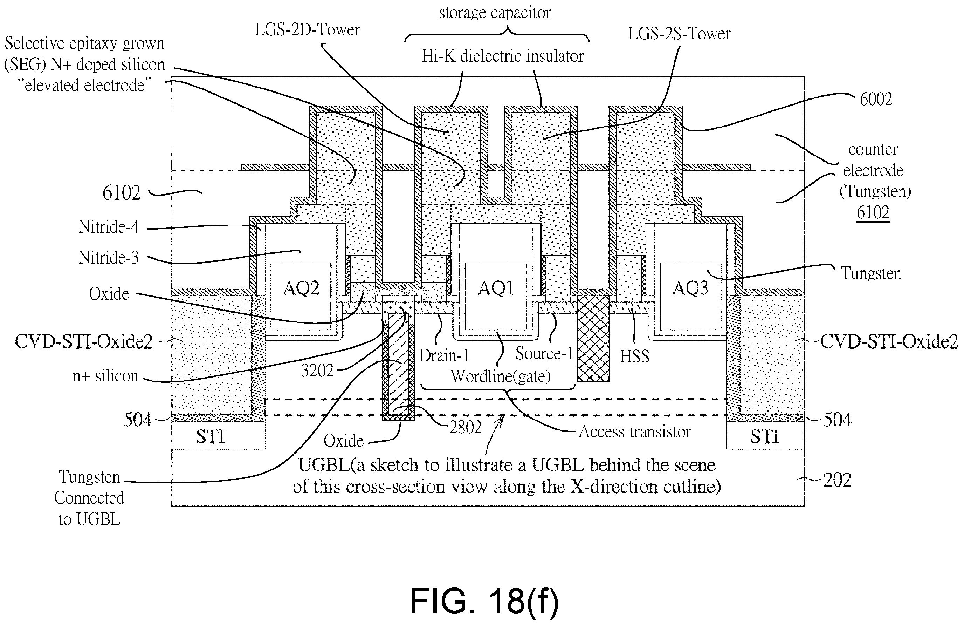

Next, as shown in FIG. 18(f), another selective epitaxy silicon growth is carried out by using the exposed LGS-2D region and the exposed LGS-2S region as seeds to create the twin-tower-like storage electrode for the storage capacitor which will be shown how to be completed in the following description (herewith are two twin towers of electrodes: that the high-raised electrode on the drain side is named as LGS-2D-Tower and the other high-raised electrode on the source side is named as LGS-2S-Tower, respectively). Subsequently, the M-Cell 1800 (or called as a HCoT cell, since the shape of the electrode is H shape) can be formed by depositing a Hi-K dielectric insulator and a thick metal layer (e.g. Tungsten) 6102, and then etch back the metal layer 6102 or use the CMP technique to polish the metal layer 6102 to result in a planar surface. This newly invented HCoT cell has a twin-tower-like H-shape storage electrode (of the storage capacitor) fully surrounded with the high-K-dielectric-insulator-2 6002 outside of which is completely covered by a counter-electrode-plate metal layer (i.e. the metal layer 6102) bused at a fixed voltage (e.g. Half-VCC).

In summary, the proposed HCoT cell which not only compacts the size of the DRAM cell but also enhances the signal-to-noise ratio during the DRAM operation. Since the capacitor is located over the access transistor and largely encompasses the access transistor as well as inventing both vertical and horizontal self-alignment techniques of arranging and connecting the geometries of these essential micro-structures in the DRAM cell, the new HCoT cell architecture can reserve the merit of at least 4 to 10 square units even when the minimum physical feature size is much less than 10 nanometers. The area of the H-capacitor may occupy 50%-70% of the HCoT cell area. The detailed description regarding the manufacture process of the HCoT cell structure could refer to the U.S. Application No. 17/337,391, filed on June 2, 2021 and entitled "MEMORY CELL STRUCTURE", and the whole content of the U.S. Application No. 17/337,391 is incorporated by reference herein.

Furthermore, the metal electrode of the capacitor in the new HCoT cell architecture offers an efficient route for heat dissipation and so the temperature of the HCoT cell during the operation could be lower accordingly, such lower temperature will then reduce both the leakage currents from the capacitor and the thermal/operational noises. Additionally, the metal electrode further encompasses the word line passing through the access transistor, and the combination of such encompassed word lines with the underground bit lines (UGBLs) made below the silicon surface could effectively shield the cross-coupling noises among different word lines/bit lines, and thus the problematic pattern sensitivity issue in traditional DRAM cell array operations could be dramatically reduced. Besides, the UGBL below the silicon surface of the present invention can flexibly lower the resistivity and capacitance of the bit lines, therefore, the signal sensitivity during the charge sharing period between the capacitor and the bit line could be improved and thus the operation speed of the new architecture of HCoT cell could be enhanced as well.

Using 4λ² for the area of the M-Cell as an example, the total bytes within the SMFA of 26 mm by 33 mm based on different technology nodes (supposing 50% DRAM cell utilization rate, that is, 50% of the SMFA is used for DRAM cell, the rest of SMFA is used for DRAM I/O circuit) could be 25 times of the total bytes of SRAM in the aforesaid Table 1, since the size of the new SRAM according to the present invention is 100λ². For example, the SMFA of 26 mm by 33 mm could at least accommodate 537GB (21.5GB×25) DRAM at technology node=5nm, and may provide more in the event the utilization rate is more than 50%. The SMFA of 26 mm by 33 mm could at least accommodate 68.5GB (2.74GB×25) DRAM at technology node=14nm, 134GB (5.36GB×25) DRAM at technology node=10nm, and 272.5GB (10.9GB×25) DRAM at technology node=7nm. Thus, a monolithic DRAM die with 64-512GB (such as 64GB, 128GB, 256GB, or 512GB) could be available, and the top of the monolithic DRAM die is covered by the counter-electrode. Of course, in consideration of tolerance, variation, and the conventional Back End of Line technology, the SMFA (26 mm by 33 mm) of the single monolithic die may accommodate smaller volume of M-Cell DRAM, such as 1/4-1/2 times DRAM size at different technology nodes in the above mentioned. For example, the single monolithic die may accommodate around 16-128GB (such as, 16, 32, 64, or 128GB) or 32-256GB (such as 32, 64, 128, or 256GB), due to the selective usage of the different technologies proposed herein and the conventional Back End of Line technology.

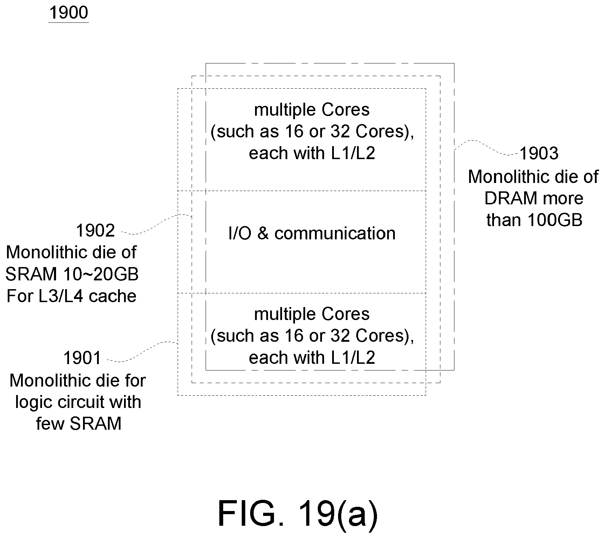

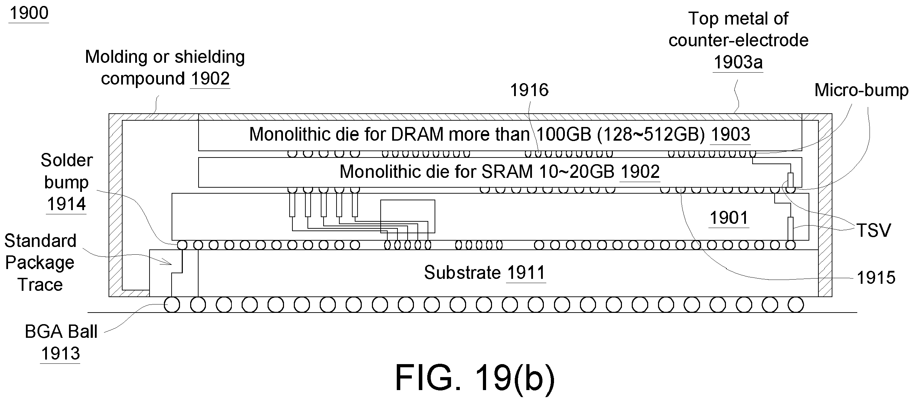

FIG. 19(a) is a schematic diagram illustrating a server processor 1900 provided by the integrated scaling and stretching platform (ISSP) according to yet another embodiment of the present disclosure. FIG. 19(b) is a cross-sectional view illustrating the server processor 1900 as shown in FIG. 19(a). In the preset embodiment, the server processor 1900 includes three monolithic dices in a single molding package, one is the single monolithic die 1901 which comprises logic circuits (such as XPU and YPU; or more than 32 or 64 Cores), I/O circuit and few L1 and L2 level caches; another is the SRAM monolithic die 1902 with 2-15GB (such as, 5-15GB SRAM, 2.5GB-7.5GB, 10GB, 20 GB, or more L3/L4 caches); and the other is the DRAM monolithic die 1903 with 16-128GB (such as, 16, 32, 64, or 128GB) or 32-256GB (such as 32, 64, 128, or 256GB) or more. Those three dices 1901, 1902 and 1903 are vertically stacked above a substrate (such as ABF substrate or silicon interposer substrate) 1911 and encapsulated by molding or shielding compound 1912. These three dice 1901, 1902 and 1903 are electrically connected to the substrate 1911 through at least one of the solder bumps 1914 and micro-bumps 1915 and 1916, respectively; and electrically connected to external devices (not shown) by the ball grid arrays (BGA ball) 1913. The top metal of counter-electrode 1903a of the DRAM monolithic die 1903 could be revealed for heat dissipation.

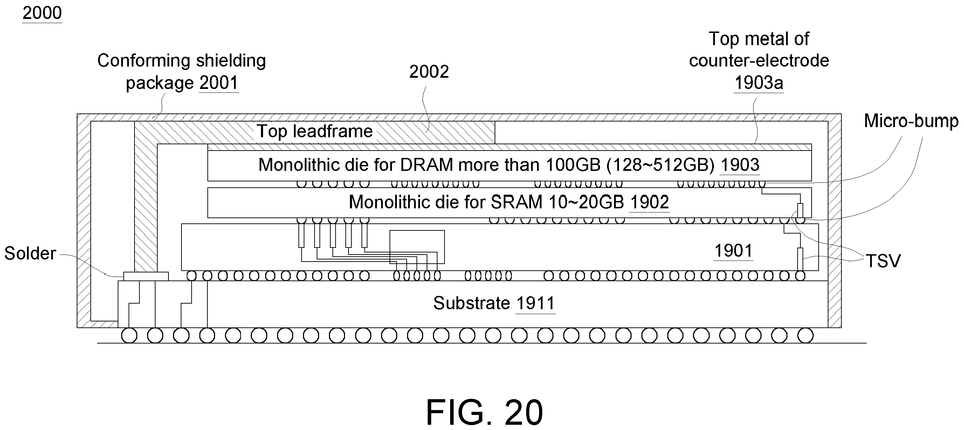

However, the structure of the single molding package is not limited to this regard. For example, FIG. 20 is a cross-sectional view illustrating the server processor 2000 according to yet another embodiment of the present disclosure. The structure of the server processor 2000 is similar to that of the server processor 1900 as shown in FIG. 19(b) except that the top metal of counter-electrode 1903a of the DRAM monolithic die 1903, in the present embodiment, could be covered by other top lead frame 2002 which not only provide reference voltage to the counter-electrode 1903a of the DRAM monolithic die 1903, but also offer another heat dissipation route for the DRAM monolithic die 1903. Then the molding/shielding compound 2001 surrounds the three dice 1901, 1902 and 1903.

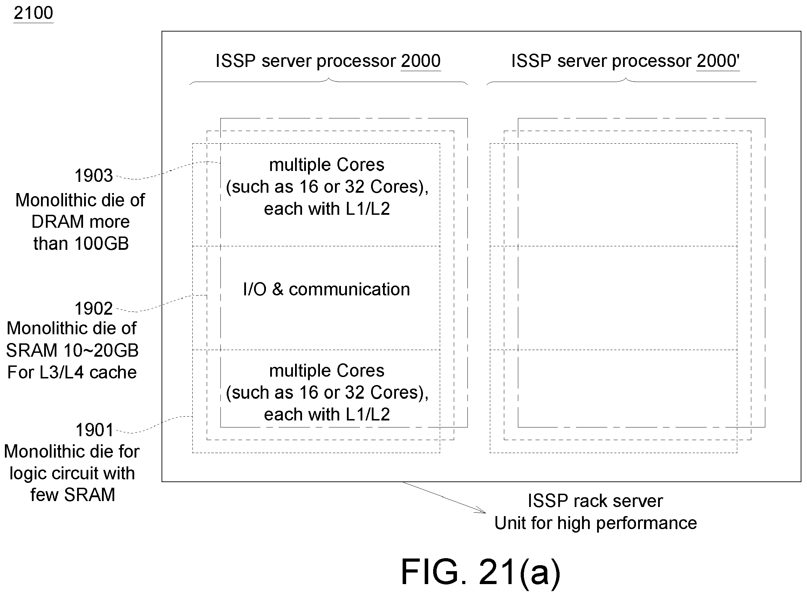

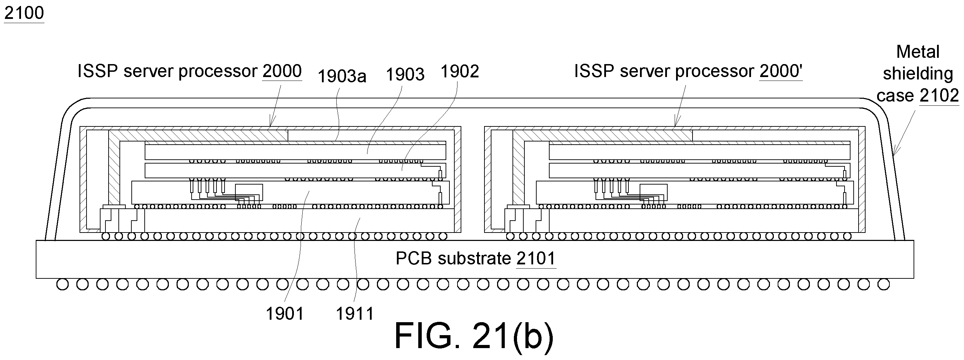

Moreover, for high performance computing, a new ISSP rack server unit 2100 including two ISSP server processors (such as, the server processors 2000 and 2000' as shown above) attached to another substrate (such as ABF substrate or PCB substrate) 2101 and encapsulated by metal shielding casing 2102 is proposed. FIG. 21 (a) is a diagram illustrating an ISSP rack server unit 2100 provided by the integrated scaling and stretching platform (ISSP) according to yet another embodiment of the present disclosure. FIG. 21(b) is a cross-sectional view illustrating the rack server unit 2100 as shown in FIG. 21(a). Such new ISSP rack server unit 2100 may include 32-512GB or 1TB DRAM, and 4-30GB or 40GB SRAM. Furthermore, since the all DRAM is encapsulated by shielding compound and metal shielding casing 2102, the EMI issues could be improved. Additionally, since the DRAM chip (such as, the DRAM monolithic die 1903) is quite close to the logic chip (such as, the single monolithic die 1901) (for few mm) in each ISSP server processor (such as, the server processor 2000), the signal propagation distortion is dramatically reduced in the ISSP rack server unit 2100.

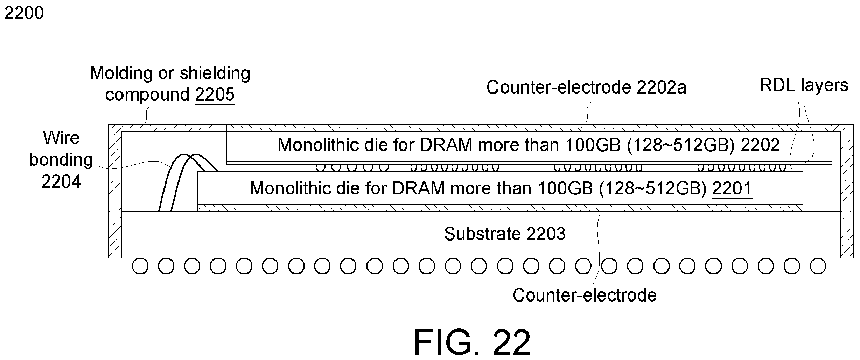

To increase the DRAM capacity in the ISSP rack server unit 2200, two monolithic DRAM chips 2201 and 2202 based on M-Cell structure 1800 could be encapsulated in a molding/shielding compound 2205. FIG. 22 is a diagram illustrating an ISSP rack server unit 2200 provided by the integrated scaling and stretching platform (ISSP) according to yet another embodiment of the present disclosure. In the present embodiment, the DRAM chip (the bottom one) 2201 is up-side-down and bonded (such as RDL with micro bumping or copper pillar bumping) to another DRAM chip 2202(the top one), and the bottom DRAM chip 2201 is electrically coupled to the substrate (such as ABF substrate or silicon interposer substrate) 2203 by wire bonding 2204. The signals of the top DRAM chip 2202 will be transmitted to the substrate 2203 through the bottom DRAM chip 2201. The counter electrodes 2202a of the top DRAM chip 2202 could be revealed for better heat dissipation. This "Dual DRAM package" as shown in FIG. 22 may have 32-512GB (such as 256GB, 512GB), or 1TB storage capacity.

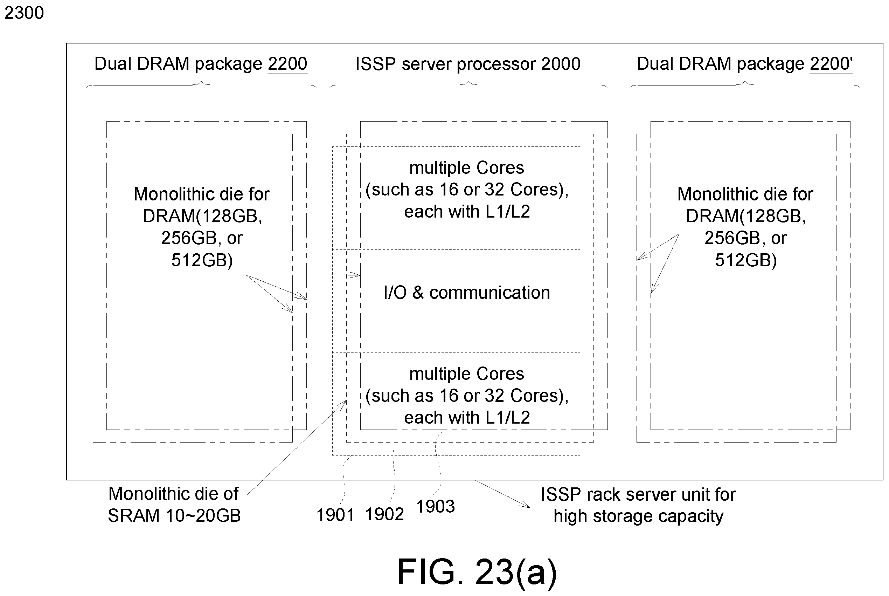

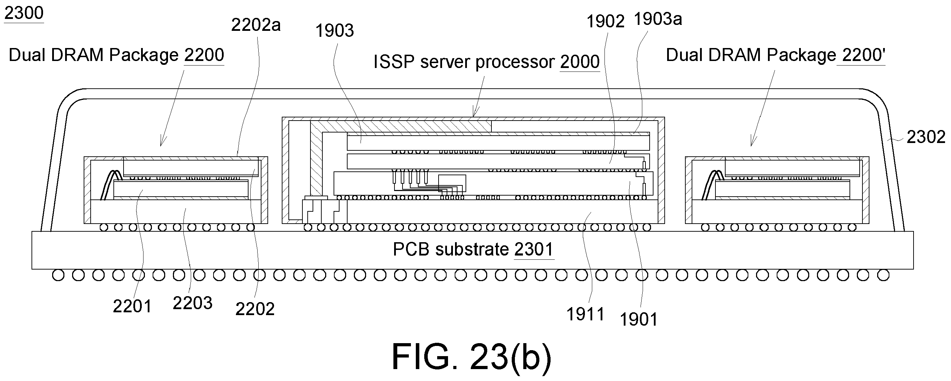

FIG. 23(a) is a diagram illustrating an ISSP rack server unit 2300 provided by the integrated scaling and stretching platform (ISSP) according to yet another embodiment of the present disclosure. FIG. 23(b) is a cross-sectional view illustrating the server processor 2300 as shown in FIG. 23(a). In the present embodiment, another ISSP rack server unit 2300 for high storage capacity is proposed and comprises one aforesaid ISSP server processor (such as, the server processor 2000 as shown in FIG. 19(a)) and two aforesaid "Dual DRAM packages" (i.e. 2200 and 2200') attached to a substrate (such as ABF substrate or PCB substrate) 2301, and then encapsulated by metal shielding case 2302.

Such new ISSP rack server unit 2300 may include 80-640GB (such as 512GB), 1TB or 2TB DRAM, and 2-15GB (such as 10 GB) or more SRAM. Furthermore, since the all DRAMs are encapsulated by shielding compound 1912 and metal shielding casing 2302, the EMI issues could be improved. Additionally, since the top of the ISSP server processor (the server processor 1900) and the Dual DRAM package (the ISSP rack server unit 2200) are covered by the counter electrodes of the DRAM chip (e.g. the top metal of counter-electrode 1903a of the DRAM monolithic die 1903 and/or the counter electrodes 2202a of the top DRAM chip 2202), the metal shielding case 2302 could be thermally coupled (not shown) to those counter electrodes1903a and/or 2202a for better heat dissipation.

Monolithic integration on a single die which enables the success of Moore's Law is now facing its limits, especially due to limits of photography printing technologies. On one hand the minimum feature size printed on the die is very costly to be scaled in its dimension, but on the other hand the die size is limited by a Scanner Maximum Field Area. But more and diversified functions of processors are emerging, such requirement are hard to integrate on a monolithic die. In addition, somewhat duplicated existence of small eSRAMs on each major function die and external or embedded DRAMs are not a desirable and optimized solution. Based on the integrated scaling and/or stretching platform (ISSP) in a monolithic die or SOC die:
(1) A single major function block like FPGA, TPU, NPU, CPU or GPU can be shrunk to a much smaller size;
(2) More SRAM could be formed in the monolithic die; and
(3) Two or more major function block, such as GPU and FPGA (or other combination of), which has also gone through this ISSP to become smaller, can be integrated together in the same monolithic die.
(4) More levels of caches could be existed in a monolithic die.
(5) Such ISSP monolithic die could be combined with another dies (such as eDRAMs) based on heterogeneous integration.
(6) HPC Die 1 with L1&L2 caches could be electrically connected (such as wire bonding or flip chip bonding) to one or more HBSRAM Dice 2 which are utilized as L3&L4 caches in a single package, each of the HPC Die 1 and the HBSRAM Die 2 has SMFA.
(7) No HMB memory or only few HBM memory is required in the ISSP.
(8) For data center and cloud computing application, the ISSP server processor is proposed with three monolithic dice in a single molding package, one is single monolithic die which comprises logic circuits (such as XPU and YPU; more than 32 or 64 cores), I/O circuit and a few L1 and L2 level SRAM caches; another is SRAM monolithic die with 10GB, 20 GB, or more L3/L4 caches; and the other is DRAM monolithic die with 128GB, 256GB, 512GB, or more.
(9) Two or more ISSP server processors could be attached to a PCB substrate and encapsulated by metal shielding casing, as an ISSP rack server unit for high performance computing.
(10) One aforesaid ISSP server processor and two "Dual DRAM packages" could be attached to a PCB substrate, and then encapsulated by metal shielding case, as an ISSP rack server unit for high storage capacity.

While the invention has been described by way of example and in terms of the preferred embodiment (s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. An IC package, comprising:
a substrate;
a first monolithic die in which a processing unit circuit is formed; and
a second monolithic die in which a plurality of static random access memory (SRAM) arrays are formed, wherein the plurality of SRAM arrays comprise at least 2-15G Bytes; and
a third monolithic die in which a plurality of dynamic random access memory (DRAM) arrays are formed, wherein the plurality of DRAM arrays comprise at least 16-256G Bytes;
wherein the first monolithic die, the second monolithic die and the third monolithic die are vertically stacked above the substrate.

2. The IC package according to claim 1, wherein the first monolithic die has a die area the same or substantially the same as a scanner maximum field area defined by a specific technology process node; the second monolithic die has a die area the same or substantially the same as the scanner maximum field area defined by the specific technology process node; and the third monolithic die has a die area the same or substantially the same as the scanner maximum field area defined by the specific technology process node.

3. The IC package according to claim 2, wherein the scanner maximum field area is not greater than 26 mm by 33 mm, or 858 mm².

4. The IC package according to claim 1, wherein the first monolithic die and the second monolithic die are enclosed within a single package; wherein the third monolithic die is electrically connected to the first monolithic die through the second monolithic die.

5. The IC package according to claim 1, wherein the plurality of DRAM arrays comprise at least 128G Bytes, 256G Bytes or 512G Bytes.

6. The IC package according to claim 1, wherein the processing unit circuit comprising a first processing unit circuit and a second processing unit circuit, wherein the first processing unit circuit comprises a plurality of first logic cores, and each of the plurality of first logic cores comprises a first SRAM set; the second processing unit circuit comprises a plurality of second logic cores, and each of the plurality of second logic cores includes a second SRAM set, wherein the first processing unit circuit or the second processing unit circuit is selected from a group consisting of a graphic processing unit (GPU), a central processing unit (CPU), a tensor processing unit (TPU), a network processing unit (NPU) and a field programmable gate array (FPGA).

7. The IC package according to claim 1, wherein the plurality of DRAM arrays comprise a counter electrode on the top of the third monolithic die.

8. The IC package according to claim 7, further comprising a molding or shielding compound encapsulating the first monolithic die, the second monolithic die, and the third monolithic die, wherein a top surface of the counter electrode is revealed and not covered by the molding or shielding compound.

9. The IC package according to claim 8, further comprising:
a top lead-frame contacted to the top surface of the counter electrode and the substrate; and
a molding or shielding compound encapsulating the first monolithic die, the second monolithic die, the third monolithic die, and the top lead-frame.

10. An IC package, comprising:
a substrate;
a first DRAM monolithic die in which a first plurality of DRAM arrays are formed, wherein the first plurality of DRAM arrays comprise at least 16-256G Bytes, and the first plurality of DRAM arrays include a first counter electrode on the top portion of the first DRAM monolithic die; and
a second DRAM monolithic die in which a second plurality of DRAM arrays are formed, wherein the second plurality of DRAM arrays comprise at least 16-256G Bytes, and the second plurality of DRAM arrays comprise a second counter electrode on the top portion of the second DRAM monolithic die;
wherein the first DRAM monolithic die and the second DRAM monolithic die are vertically stacked over the substrate, the second counter electrode of the second DRAM monolithic die is contacted to the substrate, and the first DRAM monolithic die is electrically connected to the substrate through the second DRAM monolithic die.

11. The IC package according to claim 10, wherein the second DRAM monolithic die is electrically coupled to the substrate through electrical bonding.

12. An integration system, comprising:
a carrier substrate;
a first IC package according to claim 1, wherein the first IC package is bonded to the carrier substrate;
a second IC package according to claim 1 or claim 10, wherein the second IC package is bonded to the carrier substrate; and
a metal shielding case encapsulating the first IC package and the second IC package.

13. The integration system according to claim 12, further comprising:
a third IC package according to claim 10, wherein the third IC package is bonded to the carrier substrate; and
a metal shielding case encapsulating the first IC package, the second IC package, and the third IC package; wherein the second IC package is the IC package according to claim 10.

14. The integration system according to claim 13, the metal shielding case is thermally coupled to a first counter electrode on the top portion of the first DRAM monolithic die of the second IC package, and thermally coupled to a first counter electrode on the top portion of the first DRAM monolithic die of the third IC package.
